(19) Europäisches Patentamt
European Patent Office
Office européen des brevets

(11) EP 4 177 978 A1

(12) EUROPEAN PATENT APPLICATION

(43) Date of publication:
**10.05.2023 Bulletin 2023/19**

(21) Application number: **21206691.4**

(22) Date of filing: **05.11.2021**

(51) International Patent Classification (IPC):
***H01L 51/50*** *(2006.01)*

(52) Cooperative Patent Classification (CPC):
**H10K 85/60; H10K 50/171**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Novaled GmbH**
**01099 Dresden (DE)**

(72) Inventors:
- **GANIER, Jerome**
  **01099 Dresden (DE)**
- **WERNER, Ansgar**
  **01099 Dresden (DE)**
- **KIM, Hun**
  **01099 Dresden (DE)**
- **FURNO, Mauro**
  **01099 Dresden (DE)**

(74) Representative: **Bittner, Thomas L.**
**Boehmert & Boehmert Anwaltspartnerschaft mbB**
**Pettenkoferstrasse 22**
**80336 München (DE)**

# (54) ORGANIC LIGHT EMITTING DIODE, A DISPLAY DEVICE COMPRISING THE SAME AND A LIGHTING DEVICE COMPRISING THE SAME

(57) The present invention relates to an organic light emitting diode, a display device comprising the same and a lighting device comprising the same.

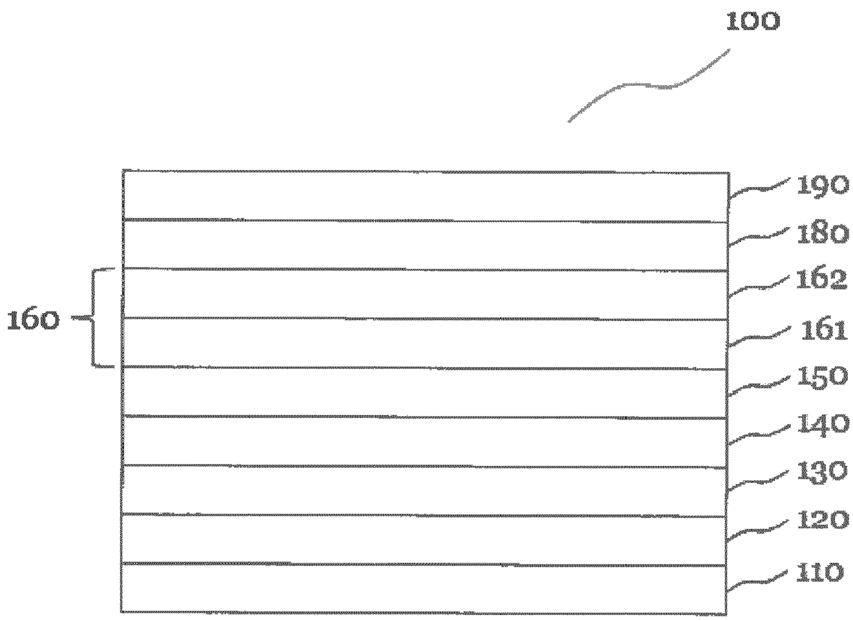


Fig. 1

EP 4 177 978 A1

## Description

TECHNICAL FIELD

The present invention relates to an organic light emitting diode, a display device comprising the same and a lighting device comprising the same.

Organic light-emitting diodes (0LEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. To facilitate electron transport from the cathode into the ETL, the OLED may further comprise an electron injection layer (EIL) arranged between the cathode and the ETL. In this regard, the HTL, the EML, the ETL, and the EIL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

A variety of organic electronic diodes comprising different electron transport materials are well known in the art. However, there is still a need to improve the performance of such devices, in particular to improve the performance of single-emission-layer and multi-emission-layer top emission OLEDs, specifically with regard to efficiency and voltage.

It is, therefore, the object of the present invention to provide an organic light emitting diode, overcoming drawbacks of the prior art, in particular a single-emission-layer top emission OLED with improved performance, in particular with improved efficiency, more particularly with improved efficiency while maintain good driving voltage.

DISCLOSURE

The object is achieved by an organic light emitting diode comprising a non-transparent substrate, an anode, a cathode, an emission layer, an electron injection layer, and an electron transport layer;
wherein

- the emission layer, the electron injection layer and the electron transport layer are arranged between the anode and the cathode;

- the electron injection layer and the electron transport layer are arranged between the emission layer and the cathode;

- the electron injection layer is in direct contact to the electron transport layer;

- the electron injection layer is in direct contact to the cathode; and

- the electron injection layer consists of a compound of Formula (I) or of a mixture of two or more compounds of Formula (I)

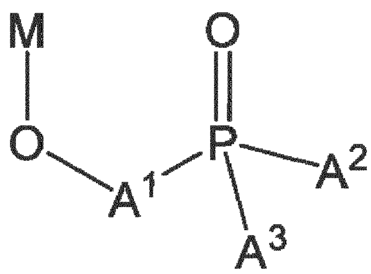

(I)

wherein

- M is an alkali metal;

- $A^1$ is selected from $C_6$ to $C_{60}$ arylene or $C_2$ to $C_{42}$ heteroarylene;

- $A^2$ and $A^3$ are independently selected from the group consisting of $C_6$ to $C_{30}$ aryl, $C_2$ to $C_{30}$ heteroaryl, and $C_1$ to $C_{16}$ alkyl;

- each $Ar^1$ to $Ar^3$ may independently be unsubstituted or substituted with one or more substituents independently selected from the group consisting of $C_6$ to $C_{12}$ aryl, $C_3$ to $C_{11}$ heteroaryl, $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN, -O-Li and $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $A^2$ and $A^3$ may be linked to each other.

The object is further achieved by a display device comprising the organic light emitting diode according to the invention.

Finally, the object is achieved by a lighting device comprising the organic light emitting diode according to the invention.

<u>Electron injection layer (EIL)</u>

*Compound of formula (I) in the EIL*

The organic electronic device comprises at least one electron injection layer, that is, may comprise only one electron injection layer or two or more electron injection layers, wherein at least one of the two or more electron injection layers consists of a compound of Formula (I) or of a mixture of two or more compounds of Formula (I). If the organic electronic device comprises only one electron injection layer this layer consists of a compound of Formula (I) or of a mixture of two or more compounds of Formula (I). If the organic electronic device comprises two or more electron injection layers, at least one of these layers consists of a compound of Formula (I) or of a mixture of two or more compounds of Formula (I).

In the compound of formula (I) M may be lithium (Li).

$A^1$ may be selected from $C_6$ to $C_{54}$ arylene or $C_2$ to $C_{39}$ heteroarylene. $A^1$ may be selected from $C_6$ to $C_{48}$ arylene or $C_2$ to $C_{36}$ heteroarylene. $A^1$ may be selected from $C_6$ to $C_{42}$ arylene or $C_2$ to $C_{33}$ heteroarylene. $A^1$ may be selected from $C_6$ to $C_{36}$ arylene or $C_2$ to $C_{30}$ heteroarylene $A^1$ may be selected from $C_6$ to $C_{30}$ arylene or $C_2$ to $C_{24}$ heteroarylene. $A^1$ may be selected from $C_6$ to $C_{24}$ arylene or $C_2$ to $C_{21}$ heteroarylene. $A^1$ may be selected from $C_6$ to $C_{18}$ arylene or $C_2$ to $C_{17}$ heteroarylene. $A^1$ may be selected from $C_6$ to $C_{12}$ arylene or $C_2$ to $C_9$ heteroarylene. $A^1$ may be unsubstituted or substituted.

$A^1$ may be selected from $C_6$ to $C_{54}$ arylene or $C_2$ to $C_{39}$ N-containing heteroarylene. $A^1$ may be selected from $C_6$ to $C_{48}$ arylene or $C_2$ to $C_{36}$ N-containing heteroarylene. $A^1$ may be selected from $C_6$ to $C_{42}$ arylene or $C_2$ to $C_{33}$ N-containing heteroarylene. $A^1$ may be selected from $C_6$ to $C_{36}$ arylene or $C_2$ to $C_{30}$ N-containing heteroarylene $A^1$ may be selected from $C_6$ to $C_{30}$ arylene or $C_2$ to $C_{24}$ N-containing heteroarylene. $A^1$ may be selected from $C_6$ to $C_{24}$ arylene or $C_2$ to $C_{21}$ N-containing heteroarylene. $A^1$ may be selected from $C_6$ to $C_{18}$ arylene or $C_2$ to $C_{17}$ N-containing heteroarylene. $A^1$ may be selected from $C_6$ to $C_{12}$ arylene or $C_2$ to $C_9$ N-containing heteroarylene. $A^1$ may be unsubstituted or substituted.

$A^1$ may be selected from the group consisting of pyridinylene, quinolinylene, phenylene, naphtylene, phenanthrene, dibenzofurane, and carbazole.

That is, $A^1$ may be selected from the group consisting of:

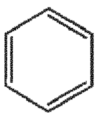 ; 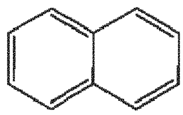 ; 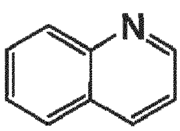 ; 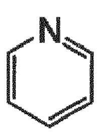 ; and 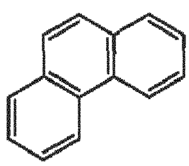 ;

wherein the respective $A^1$ may be unsubstituted or substituted with one or more substituents independently selected from hydrogen, $C_1$ to $C_6$ alkyl, D, $C_3$ to $C_6$ branched alkyl, $C_3$ to $C_6$ cyclic alkyl, partially or perfluorinated $C_1$ to $C_6$ alkyl.

$A^1$ may be selected from the group consisting of:

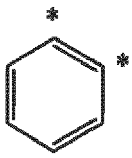 ; 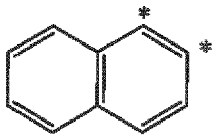 ; 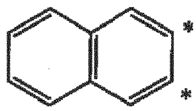 ; 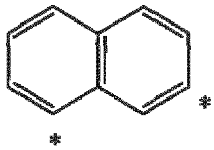 ; 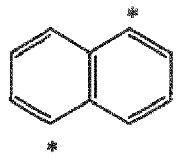 ; 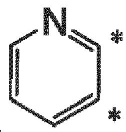 ;

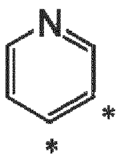 ; 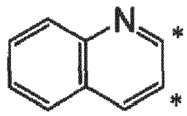 ; 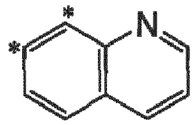 ; 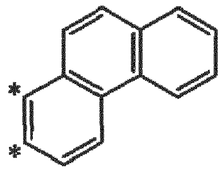 ; 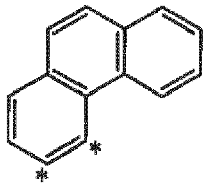 ;

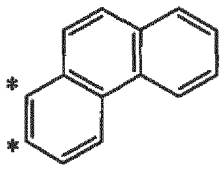 ; 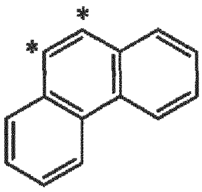 ; 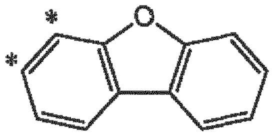 ; 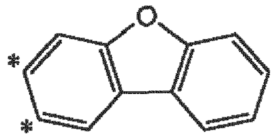 ;

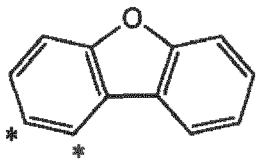 ; 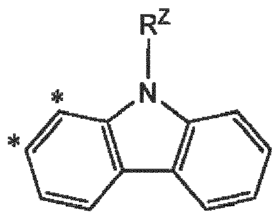 ; 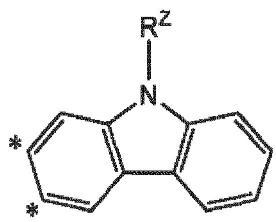 ;

and

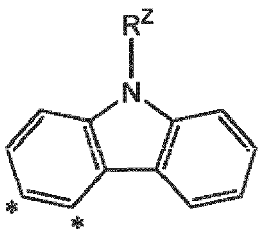

wherein one asterisk symbol "*" represents the binding position to the moiety O-M and the other asterisk symbol "*" represents the binding position to $P(=O)A^2A^3$; $R^z$ is independently selected from hydrogen, $C_1$ to $C_6$ alkyl, D, $C_3$ to $C_6$ branched alkyl, $C_3$ to $C_6$ cyclic alkyl, or partially or perfluorinated $C_1$ to $C_6$ alkyl; and wherein the respective $A^1$ may be unsubstituted or substituted.

$A^1$ may comprise a 6-membered aromatic ring and the moieties -O-M and $P(=O)A^2A^3$ are bonded to said 6-membered aromatic ring in ortho-position with respect to each other. In this regard, it may be provided that $A^1$ comprises only one 6-membered aromatic ring or two or more aromatic rings, wherein the two or more aromatic rings may be bonded to each other, especially by a single bond, such as in biphenylene, or may be condensed, such as in naphthylene. In the latter case, it may be provided that the 6-membered aromatic ring is part of the condensed ring system. Respective examples of $A^1$ groups are

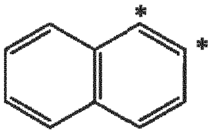 ; 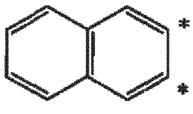 ; 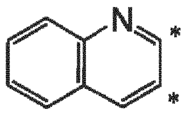 ; 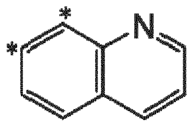 ; 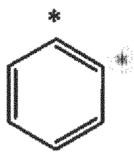 ; 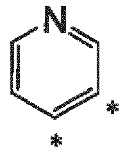 ;

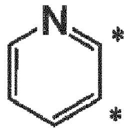

and the like.

$A^1$ may be unsubstituted or substituted with one or more substituents independently selected from the group consisting $C_1$ to $C_6$ alkyl, D, $C_3$ to $C_6$ branched alkyl, $C_3$ to $C_6$ cyclic alkyl, partially or perfluorinated $C_1$ to $C_6$ alkyl, halogen, CN and $PO(R^{10})_2$, and $R^{10}$ is independently selected from $C_6$ to $C_{12}$ aryl or $C_3$ to $C_{12}$ heteroaryl.

$A^1$ may be unsubstituted or substituted with one or more substituents, preferably one substituent $PO(R^{10})_2$, wherein $R^{10}$ is independently selected from $C_6$ to $C_{12}$ aryl or $C_3$ to $C_{12}$ heteroaryl.

$A^1$ may be unsubstituted or substituted with one or more substituents, preferably one substituent $PO(R^{10})2$, wherein $R^{10}$ is independently selected from phenyl or pyridinyl.

$A^1$ may be selected from $C_6$ to $C_{20}$ arylene or $C_2$ to $C_{18}$ N-containing heteroarylene, wherein $A^1$ may be unsubstituted or substituted with one or more substituents independently selected from the group consisting $C_1$ to $C_6$ alkyl, D, $C_3$ to $C_6$ branched alkyl, $C_3$ to $C_6$ cyclic alkyl, partially or perfluorinated $C_1$ to $C_6$ alkyl, halogen, CN and $PO(R^{10})2$, and $R^{10}$ is independently selected from $C_6$ to $C_{12}$ aryl or $C_3$ to $C_{12}$ heteroaryl.

$A^2$ and $A^3$ may be independently selected from $C_6$ to $C_{54}$ aryl or $C_2$ to $C_{39}$ heteroaryl. $A^2$ and $A^3$ may be independently selected from $C_6$ to $C_{48}$ aryl or $C_2$ to $C_{36}$ heteroaryl. $A^2$ and $A^3$ may be independently selected from $C_6$ to $C_{42}$ aryl or $C_2$ to $C_{33}$ heteroaryl. $A^2$ and $A^3$ may be independently selected from $C_6$ to $C_{36}$ aryl or $C_2$ to $C_{30}$ heteroaryl. $A^2$ and $A^3$ may be independently selected from $C_6$ to $C_{30}$ aryl or $C_2$ to $C_{24}$ heteroaryl. $A^2$ and $A^3$ may be independently selected from $C_6$ to $C_{24}$ aryl or $C_2$ to $C_{21}$ heteroaryl. $A^2$ and $A^3$ may be independently selected from $C_6$ to $C_{18}$ aryl or $C_2$ to $C_{17}$ heteroaryl. $A^2$ and $A^3$ may be independently selected from $C_6$ to $C_{12}$ aryl or $C_2$ to $C_9$ heteroaryl. $A^2$ and $A^3$ may be independently unsubstituted or substituted.

$A^2$ and $A^3$ may be independently selected from $C_6$ to $C_{54}$ aryl or $C_2$ to $C_{39}$ N-containing heteroaryl. $A^2$ and $A^3$ may be independently selected from $C_6$ to $C_{48}$ aryl or N-containing $C_2$ to $C_{36}$ heteroaryl. $A^2$ and $A^3$ may be independently selected from $C_6$ to $C_{42}$ aryl or N-containing $C_2$ to $C_{33}$ heteroaryl. $A^2$ and $A^3$ may be independently selected from $C_6$ to $C_{36}$ aryl or $C_2$ to $C_{30}$ N-containing heteroaryl. $A^2$ and $A^3$ may be independently selected from $C_6$ to $C_{30}$ aryl or $C_2$ to $C_{24}$ N-containing heteroaryl. $A^2$ and $A^3$ may be independently selected from $C_6$ to $C_{24}$ aryl or $C_2$ to $C_{21}$ N-containing heteroaryl. $A^2$ and $A^3$ may be independently selected from $C_6$ to $C_{18}$ aryl or $C_2$ to $C_{17}$ N-containing heteroaryl. $A^2$ and $A^3$ may be independently selected from $C_6$ to $C_{12}$ aryl or $C_2$ to $C_9$ N-containing heteroaryl. $A^2$ and $A^3$ may be independently unsubstituted or substituted.

$A^2$ and $A^3$ may be independently selected from phenyl and pyridinyl.

That is, $A^2$ and $A^3$ may be independently selected from:

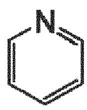 ; and 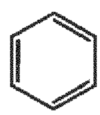

wherein the respective $A^2$ and $A^3$ may be independently unsubstituted or substituted.

$A^2$ and $A^3$ may be independently selected from:

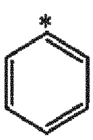 ; 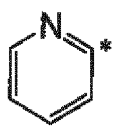 ; 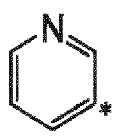 ; 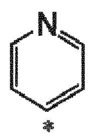

wherein the asterisk symbol "*" represents the binding position; and

wherein the respective $A^2$ and $A^3$ may independently be unsubstituted or substituted.

$A^2$ and $A^3$ may be independently unsubstituted or substituted with one or more substituents independently selected from the group consisting $C_1$ to $C_6$ alkyl, D, $C_3$ to $C_6$ branched alkyl, $C_3$ to $C_6$ cyclic alkyl, partially or perfluorinated $C_1$ to $C_6$ alkyl, halogen, -O-Li and CN.

$A^2$ and $A^3$ may be independently unsubstituted or substituted with one substituent -O-Li.

$A^2$ and $A^3$ may be independently selected from $C_6$ to $C_{12}$ arylene or $C_2$ to $C_8$ N-containing heteroarylene, wherein $A^2$ and $A^3$ may be independently unsubstituted or substituted with one or more substituents independently selected from the group consisting $C_1$ to $C_6$ alkyl, D, $C_3$ to $C_6$ branched alkyl, $C_3$ to $C_6$ cyclic alkyl, partially or perfluorinated $C_1$ to $C_6$ alkyl, halogen, -O-Li and CN.

$A^2$ and $A^3$ may (or may not) be linked to each other. $A^2$ and $A^3$ may (or may not) be linked to each other via a single bond.

The compound of the formula (I) may have a LUMO energy level from -0.90 eV to -1.90 eV, wherein the LUMO energy level is determined in the absolute scale taking vacuum energy level as zero, computed by the TURBOMOLE V6.5 program package using hybrid functional B3LYP and Gaussian 6-31G* basis set.

The compound of the formula (I) may have a HOMO-LUMO gap from 3.00 eV to 4.50 eV , wherein the LUMO energy level is determined in the absolute scale taking vacuum energy level as zero, computed by the TURBOMOLE V6.5 program package using hybrid functional B3LYP and Gaussian 6-31G* basis set.

The compound of the formula (I) may have a dipole moment from 2.30 Debye to 8.00 Debye, wherein, dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule. The dipole moment is determined by a semi-empirical molecular orbital method.

The compound of formula (I) may be selected from the group consisting of ND-1 to ND-20

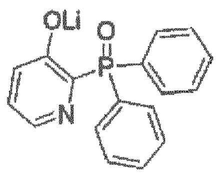

ND-1

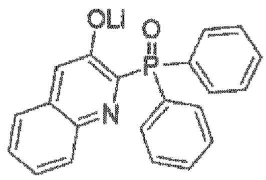

ND-2

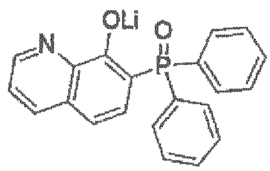

ND-3

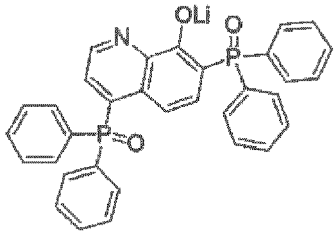

ND-4

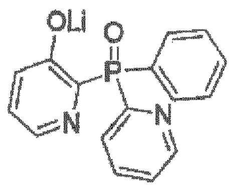

ND-5

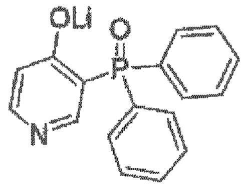

ND-6

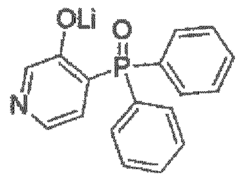

ND-7

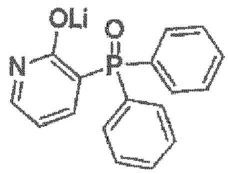

ND-8

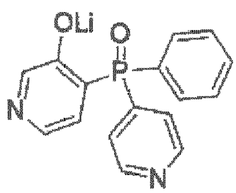

ND-9

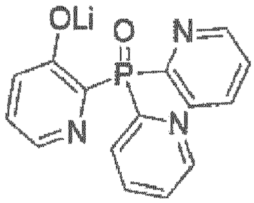

ND-10

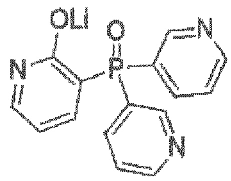

ND-11

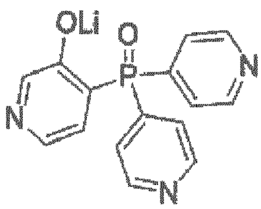

ND-12

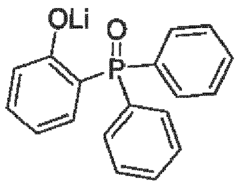

ND-13

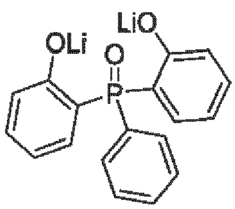

ND-14

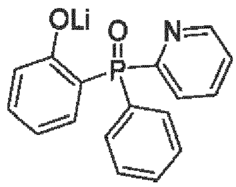

ND-15

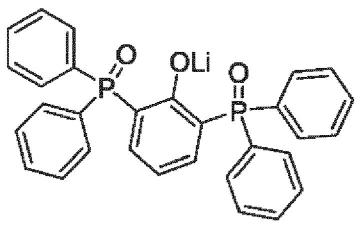

ND-16

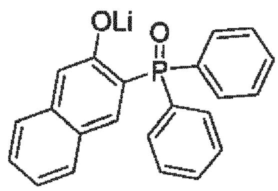

ND-17

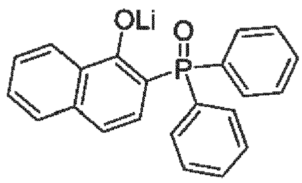

ND-18

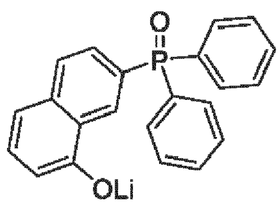

ND-19

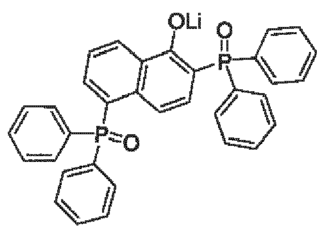

ND-20

Important physical properties of the compounds ND-1 to ND-20 are shown in the following table 1.

Table 1:

| | Orbital energies/eV | | | |
|---|---|---|---|---|
| Compound | HOMO | LUMO | HOMO/ LUMO gap | Dipole/Debye |
| ND-1 | -5..27 | -0.98 | 4.29 | 2.33 |
| ND-2 | -4.99 | -1.41 | 3.58 | 3.28 |
| ND-3 | -4.88 | -0.99 | 3.89 | 3.78 |
| ND-4 | -4.92 | -1.25 | 3.67 | 3.32 |
| ND-5 | -5.12 | -1.25 | 3.87 | 3.64 |
| ND-6 | -5.53 | -1.12 | 4.42 | 5.19 |
| ND-7 | -5.15 | -1.13 | 4.02 | 6.23 |
| ND-8 | -5.34 | -1.09 | 4.25 | 5.23 |
| ND-9 | -5.32 | -1.58 | 3.75 | 5.71 |
| ND-10 | -5.20 | -1.19 | 4.01 | 2.06 |
| ND-11 | -5.60 | -1.57 | 4.03 | 3.00 |
| ND-12 | -5-49 | -1.84 | 3.65 | 4.40 |
| ND-13 | -4.93 | -0.97 | 3.96 | 3.51 |
| ND-14 | -4.82 | -1.13 | 3.69 | 6.63 |
| ND-15 | -4.73 | -1.57 | 3.16 | 6.07 |
| ND-16 | -5.31 | -1.12 | 4.20 | 5.71 |
| ND-17 | -4.65 | -1.07 | 3.57 | 4.64 |
| ND-18 | -4.76 | -0.98 | 3.78 | 3.95 |
| ND-19 | -4.44 | -1.49 | 2.95 | 7.49 |
| ND-20 | -4.86 | -1.00 | 3.87 | 4.59 |

The dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule.

The dipole moment is determined by a semi-empirical molecular orbital method.

*Electron injection layer (EIL)*

The electron injection layer maybe free of Yb.

The electron injection layer maybe free of LiQ.

The EIL may have a thickness selected from the group consisting of: from 0.1 to 10 nm; from 0.2 to 8 nm; from 0.3 to 5 nm; from 0.5 to 3 nm; from 1 to 2 nm; and about 1.5 nm.

The electron injection layer may consist of a number of individual electron injection sublayers. In this case, the thickness of the EIL is the sum of the thicknesses of all electron injection sublayers.

The electron injection layer may be free of emitter compounds.

The electron injection layer may be free of non-phosphinoxide compounds. In particular it may be free of high triplet level aryl compounds, benzimidazole compounds, phenanthroline compounds, ketone compounds, pyrimidine compounds and triazine compounds.

Cathode electrode

The organic light emitting diode comprises a cathode electrode. The EIL is adjacent to the cathode electrode.

The EIL is in direct contact with the cathode electrode.

The electron injection layer comprises an organic compound and is therefore not a cathode electrode.

The cathode electrode does not comprise or consist of an organic compound and therefore is not an electron injection layer.

The cathode electrode may be free of organic compounds, organic metal complexes and metal halides.

The cathode electrode may comprise at least one zero-valent metal selected from the group comprising alkali metal, alkaline earth metal, rare earth metal and/or a group 3 transition metal. These metals may also be described as electropositive metals or metals with a low workfunction. Very low operating voltages and high external quantum efficiency EQE are achieved when the cathode electrode is in direct contact with an electron injection layer comprising an organic phosphine compound. Thereby, the battery life of mobile devices may be increased.

The cathode electrode may comprise at least a first cathode electrode layer. The EIL may be adjacent to the first cathode electrode layer. The EIL may be in direct contact with the first cathode electrode layer.

The electron injection layer comprises an organic compound and is therefore not a first cathode electrode layer.

The EIL may be adjacent to the first cathode electrode layer. The EIL may be in direct contact with the first cathode electrode layer.

The first cathode electrode layer does not comprise or consist of an organic compound and therefore is not an electron injection layer.

The first cathode electrode layer may be free of organic compounds, organic metal complexes and metal halides.

The first cathode electrode layer may comprises at least one zero-valent metal selected from the group comprising alkali metal, alkaline earth metal, rare earth metal and/or a group 3 transition metal. These metals may also be described as electropositive metals or metals with a low workfunction. Very low operating voltages and high external quantum efficiency EQE are achieved when the first cathode electrode layer is in direct contact with an electron injection layer comprising an organic phosphine compound. Thereby, the battery life of mobile devices may be increased.

The cathode may comprise a cathode sub-layer; the cathode sub-layer may comprise a rare earth metal; and the cathode sub-layer may be in direct contact with the electron injection layer.

The cathode may comprise a cathode sub-layer; the cathode sub-layer may consist of a rare earth metal or a mixture of two or more rare earth metals; and the cathode sub-layer may be in direct contact with the electron injection layer.

The rare earth metal may be Yb.

The cathode sub-layer may have a thickness selected from the group consisting of from 0.5 nm to 5 nm; from 1 nm to 4 nm; 1 nm to 3 nm; and about 2 nm.

In an embodiment, the cathode does not comprise a cathode sub-layer.

In an embodiment, the organic electronic device does not comprise a cathode sub-layer.

The cathode may be free of Li.

The cathode may be free of Li-containing compound.

## Electron transport layer (ETL)

The organic electronic device further comprises an electron transport layer (ETL). The electron transport layer may not comprise the compound of formula (I).

The ETL is adjacent to the EIL. The ETL is in direct contact to the EIL. The EIL is contacting sandwiched between the ETL and the cathode electrode. The EIL may be contacting sandwiched between the ETL and the first cathode electrode layer.

The ETL may be free of emitter compounds.

The electron transport layer may be free of n-dopant, especially free of electrical n-dopant. Especially, the ETL may be free of lithium quinolinolate (LiQ). In this regard, "free of" means that respective compounds (electrical dopants) are only contained in the respective layers which cannot be avoided by standard purification methods and common technical means during preparation of the respective layer. In this regards, electrical dopants are in particular, but not limited thereto, electrical n-dopants. The electrical n-dopant may be selected from a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. In particular, the first electron transport layer and the second electron transport layer may be free of an electrical n-dopant. The electrical n-dopant may be a metal salt comprising at least one metal cation and at least one anion. The metal cation of the metal salt may be selected from the group consisting of alkali metals, alkaline earth metals, and rare earth metals, alternatively from the group consisting of Li, Na, K, Rb, Cs, Mg, Ca, Sr, and Ba; alternatively from Li, Mg, Ca, and Sr. The anion of the metal salt may be selected from the group consisting of quinolinolate, phosphine oxide phenolate and borate.

In this regard, electrical n-dopants are in particular, but not limited thereto, an elemental metal, alternatively an

electropositive metal selected from alkali metals, alkaline earth metals, rare earth metals and transition metals, transition metals; a metal salt, alternatively an alkali metal salt, alkaline earth metal salt and/or rare earth metal salt, or a metal complex, alternatively an alkali metal complex, alkaline earth metal complex, transition metal complex and/or rare earth metal complex. Examples of n-doping metal salts can be LiF, LiCl, LiBr, LiI, metal borates, metal quinolinolates or mixtures thereof. Further examples of electrical n-dopants are strong chemical reducing agents. This class of "redox" n-dopants may be generically characterized by energy level of the highest occupied molecular orbital (HOMO) comparable with lowest unoccupied molecular orbital Energy Level of corresponding electron transport matrices, which is in usual OLED transport materials about -3.0 eV or less.

Electrical n-dopants may be organic compounds as disclosed in EP1837926A1, WO07107306A1 or WO07107356A1.

Especially in the embodiment in which the ETL is free of n-dopant, the ETL may comprise a compound comprising a group G, wherein G is chosen so that the dipole moment, computed by the TURBOMOLE V6.5 program package using hybrid functional B3LYP and Gaussian 6-31G* basis set, of a compound G-phenyl is ≥ 1 D and ≤ 7 D.

The unit for the dipole moment "Debye" is abbreviated with the symbol "D". If said compound in the ETL comprises a group having a certain polarity, that is a specific dipole moment within the above range or the ranges mentioned below. It is still advantageous that said compound comprises such a polar group (first polar group) if said compound comprises, in addition, a further polar group (second polar group) which is suitable to balance the dipole moment of the first polar group in a way that the total dipole moment of the compound of Formula (II) is low, for example, in case that the compound is a symmetrical molecule comprising a first polar group and a second polar group which are the same, the dipole moment could be o Debye.

Therefore, said compound cannot be characterized be referring to the total dipole moment of the compound. As a consequence, reference is made instead to an artificial compound comprising the polar group "G" and an unpolar group "phenyl". In this regards, the dipole moment $|\vec{\mu}|$ of a compound containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule. The dipole moment is determined by a semi-empirical molecular orbital method. The geometries of the molecular structures are optimized using the hybrid functional B3LYP with the 6-31G* basis set in the gas phase as implemented in the program package TURBOMOLE V6.5 (TURBOMOLE GmbH, Litzenhardtstrasse 19, 76135 Karlsruhe, Germany). If more than one conformation is viable, the conformation with the lowest total energy is selected to determine the bond lengths of the molecules. In this regard, the entire moiety G encompasses all possible substituents which may be comprised.

G may be selected so that the dipole moment of a compound G-phenyl is > 1 D; optionally ≥ 2 D; optionally ≥ 2.5 D, optionally ≥ 2.5 D, optionally ≥ 3 D, and optionally ≥ 3.5 D. G may be chosen so that the dipole moment of a compound G-phenyl is ≤ 7 D, optionally ≤ 6.5 D, optionally ≤ 6 D, optionally ≤ 5.5 D, optionally ≤ 5 D. If more than one conformational isomer of the compound G-phenyl is viable then the average value of the dipole moments of the conformational isomers of G-phenyl is selected to be in this range. Conformational isomerism is a form of stereoisomerism in which the isomers can be interconverted just by rotations about formally single bonds.

By selecting the G such that the dipole moment of a compound G-phenyl lies in the above range it is provided that the electron injection from the adjacent, distinct charge generation layer (CGL) is improved and voltage of the OLED device is decreased and the cd/A efficiency of the OLED device is increased.

The electron transport layer comprises a compound of formula (II)

$$(Ar^2)_m\text{-}(Z_k\text{-}G)_n \qquad \text{(II)}$$

wherein

- m and n are independently 1 or 2;
- k is independently 0, 1 or 2;

- $Ar^2$ is independently selected from the group consisting of $C_2$ to $C_{42}$ heteroaryl and $C_6$ to $C_{60}$ aryl,
- wherein each $Ar^2$ may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
- wherein each $C_6$ to $C_{12}$ aryl substituent on $Ar^2$ and each $C_3$ to $C_{11}$ heteroaryl substituent on $Ar^2$ may be substituted with $C_1$ to $C_4$ alkyl or halogen;
- Z is independently selected from $C_6$ to $C_{30}$ aryl,
- wherein each Z may be substituted with one or two substituents independently selected from the group consisting of $C_6$ to $C_{12}$ aryl and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
- wherein each $C_6$ to $C_{12}$ aryl substituent on Z may be substituted with $C_1$ to $C_4$ alkyl or halogen;
- G is chosen so that the dipole moment of a compound G-phenyl is ≥ 1 D and ≤ 7 D.

Exemplary compounds "G-phenyl" are listed in the following Table 2, wherein the moiety

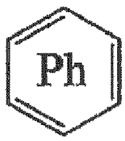

in the respective compound specifies the "phenyl" part in "G-phenyl"

Table 2:

| | Structure of G-phenyl | HOMO [eV] | LUMO [eV] | Dipole moment [D] |
|---|---|---|---|---|
| G-phenyl-1 | 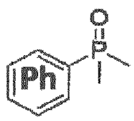 | -6.88 | -0.62 | **4.16** |
| G-phenyl-2 | 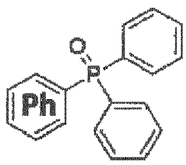 | -6.74 | -0.86 | **4.19** |
| G-phenyl-3 | 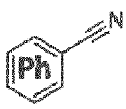 | -8.97 | 1.00 | **4.56** |

(continued)

| | Structure of G-phenyl | HOMO [eV] | LUMO [eV] | Dipole moment [D] |
|---|---|---|---|---|
| G-phenyl-4 | 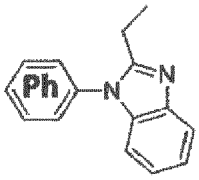 | -5.82 | -0.62 | **3.97** |
| G-phenyl-5 | 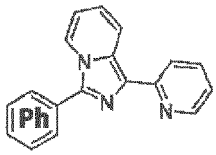 | -5.04 | -1.18 | **3.86** |
| G-phenyl-6 | 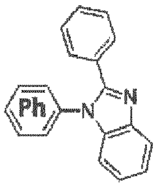 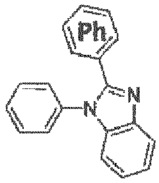 | -5.70 | -1.02 | **3.70** |
| G-phenyl-7 | 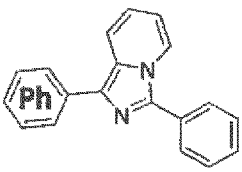 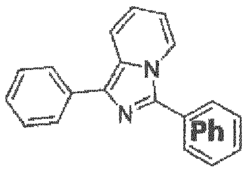 | -4.92 | -1.11 | **3.11** |
| G-phenyl-8 | 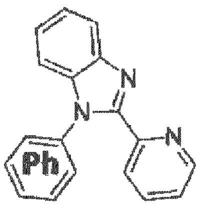 | -5.86 | -1.19 | **5.14** |
| G-phenyl-9 | 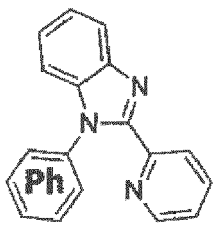 | -5.76 | -1.33 | 2.61 |
| G-phenyl-10 | 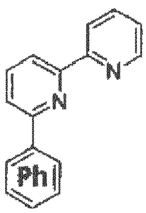 | -5.96 | -1.35 | 2.69 |

(continued)

| | Structure of G-phenyl | HOMO [eV] | LUMO [eV] | Dipole moment [D] |
|---|---|---|---|---|
| G-phenyl-11 | 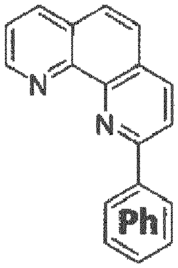 | -5.83 | -1.59 | **2.67** |
| G-phenyl-12 | 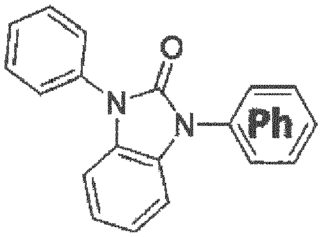 | -5.54 | -0.48 | **2.12** |
| G-phenyl-13 | 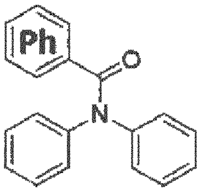 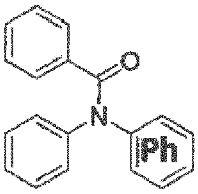 | -5.79 | -1.06 | **3.33** |
| G-phenyl-14 | 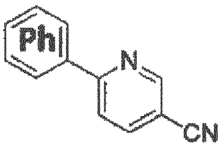 | -6.59 | -2.08 | **4.79** |
| G-phenyl-15 | 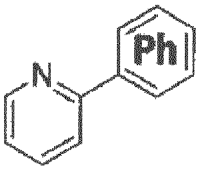 | -6.12 | -1.13 | **1.71** |
| G-phenyl-16 | 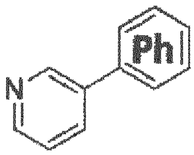 | -6.32 | -0.98 | **2.31** |
| G-phenyl-17 | 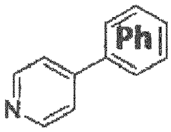 | -6.57 | -1.19 | **2.75** |

(continued)

| | Structure of G-phenyl | HOMO [eV] | LUMO [eV] | Dipole moment [D] |
|---|---|---|---|---|
| G-phenyl-18 | 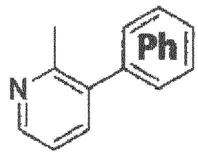 | -6.28 | -0.77 | **2.00** |
| G-phenyl-19 | 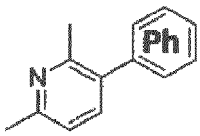 | -6.12 | -0.69 | **1.50** |
| G-phenyl-20 | 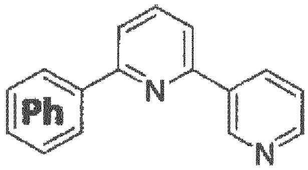 | -6.10 | -1.41 | **3.51** |
| G-phenyl-21 | 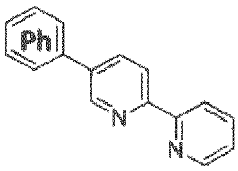 | -6.10 | -1.38 | **2.98** |
| G-phenyl-22 | 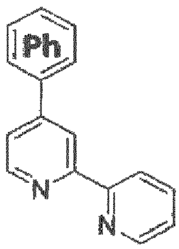 | -6.47 | -1.31 | **3.46** |
| G-phenyl-23 | 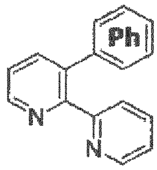 | -6.19 | -1.03 | **3.02** |
| G-phenyl-24 | 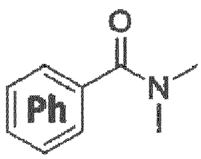 | -6.35 | -0.17 | **3.62** |

(continued)

| | Structure of G-phenyl | HOMO [eV] | LUMO [eV] | Dipole moment [D] |
|---|---|---|---|---|
| G-phenyl-25 | 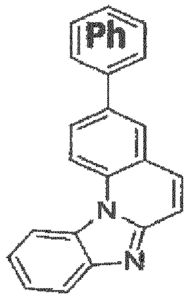 | -5.54 | -1.58 | **3.49** |
| G-phenyl-26 | 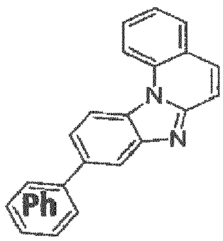 | -5.60 | -1.61 | **3.39** |
| G-phenyl-27 | 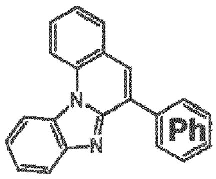 | -5.48 | -1.67 | **2.76** |
| G-phenyl-28 | 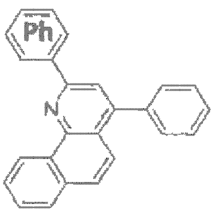 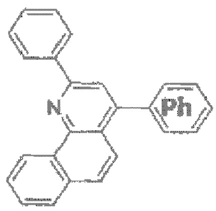 | -5.63 | -1.56 | **1.84** |
| G-phenyl-29 | 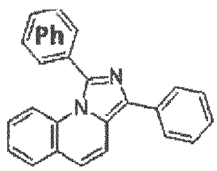 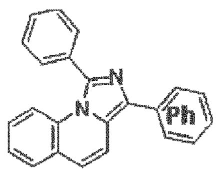 | -5.02 | -1.39 | **2.96** |
| G-phenyl-30 | 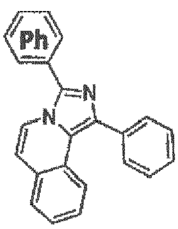 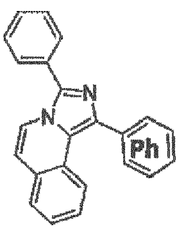 | -5.08 | -1.13 | **2.70** |

(continued)

| | Structure of G-phenyl | HOMO [eV] | LUMO [eV] | Dipole moment [D] |
|---|---|---|---|---|
| G-phenyl-31 | 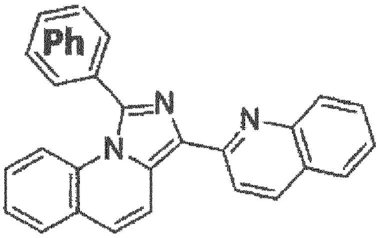 | -5-07 | -1.58 | **2.29** |
| G-phenyl-32 | 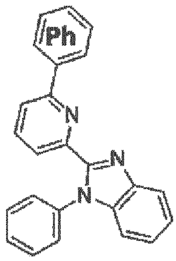 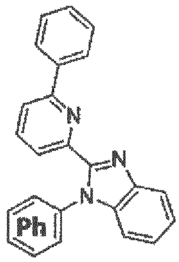 | -5.81 | -1.19 | **4.61** |
| G-phenyl-33 | 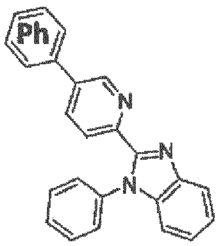 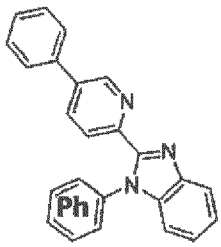 | -5.78 | -1.42 | **5.20** |
| G-phenyl-34 | 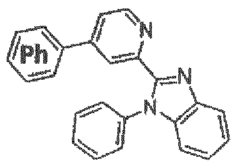 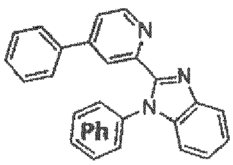 | -5.84 | -1.38 | **5.63** |
| G-phenyl-35 | 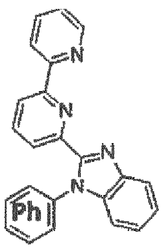 | -5.83 | -1.35 | **3.37** |
| G-phenyl-36 | 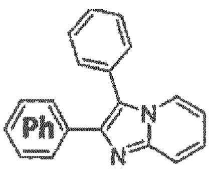 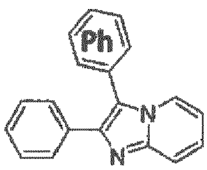 | -5.37 | -0.98 | **3-32** |

(continued)

| | Structure of G-phenyl | HOMO [eV] | LUMO [eV] | Dipole moment [D] |
|---|---|---|---|---|
| G-phenyl-37 | 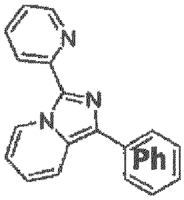 | -4.94 | -1.15 | **1.81** |
| G-phenyl-38 | 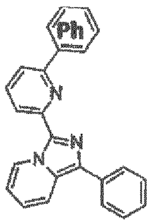 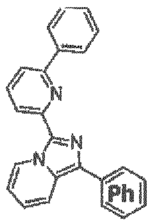 | -4.94 | -1.16 | **2.12** |
| G-phenyl-39 | 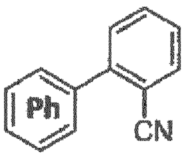 | -6.52 | -1.47 | **4.17** |
| G-phenyl-40 | 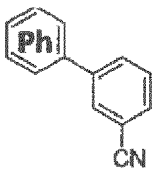 | -6.56 | -1.46 | **4.85** |
| G-phenyl-41 | 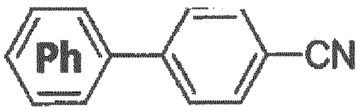 | -6.53 | -1.67 | **5.27** |
| G-phenyl-42 | 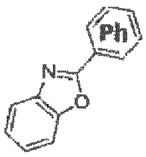 | -6.00 | -1.43 | **1.14** |
| G-phenyl-43 | 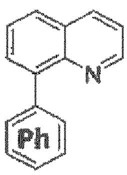 | -5.84 | -1.47 | **1.94** |
| G-phenyl-44 | 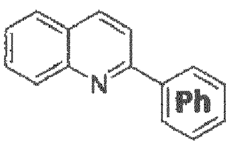 | -5.97 | -1.56 | **1.53** |

(continued)

| | Structure of G-phenyl | HOMO [eV] | LUMO [eV] | Dipole moment [D] |
|---|---|---|---|---|
| G-phenyl-45 | 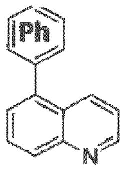 | -6.01 | -1.42 | **2.31** |
| G-phenyl-46 | 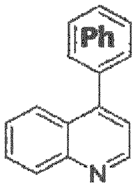 | -6.09 | -1.47 | **2.57** |
| G-phenyl-47 | 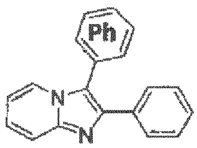 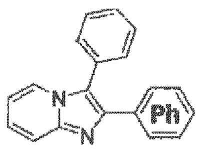 | -5.37 | -0.98 | **3-32** |
| G-phenyl-48 | 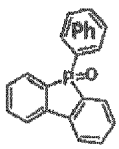 | -6.22 | -1.47 | **4.49** |
| G-phenyl-49 | 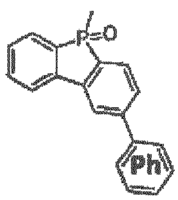 | -6.15 | -1.55 | **4.79** |
| G-phenyl-50 | 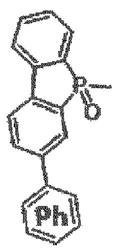 | -5.95 | -1.58 | **4.45** |
| G-phenyl-51 | 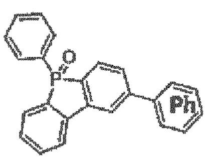 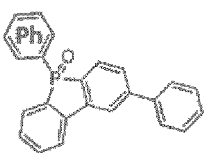 | -6.10 | -1.57 | **4.65** |

(continued)

| | Structure of G-phenyl | HOMO [eV] | LUMO [eV] | Dipole moment [D] |
|---|---|---|---|---|
| G-phenyl-52 | 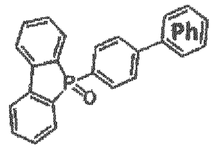 | -6.14 | -1.47 | **4.59** |
| G-phenyl-53 | 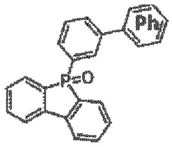 | -6.12 | -1.48 | **4.26** |
| G-phenyl-54 | 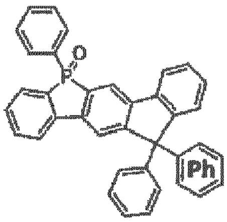 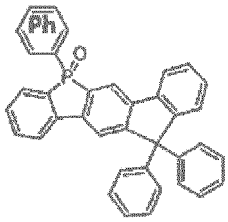 | -5.71 | -1.60 | **4.55** |
| G-phenyl-55 | 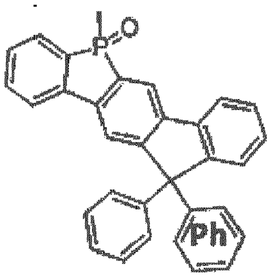 | -5.74 | -1.60 | **4.73** |
| G-phenyl-56 | 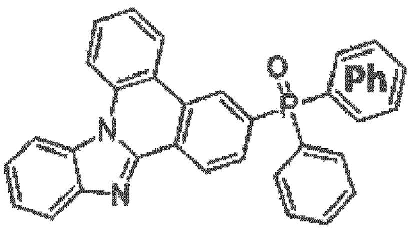 | -5.75 | -1.62 | **-6.70** |

(continued)

| | Structure of G-phenyl | HOMO [eV] | LUMO [eV] | Dipole moment [D] |
|---|---|---|---|---|
| G-phenyl-57 | 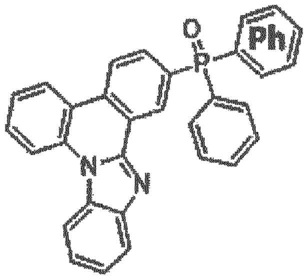 | -5.68 | -1.61 | **6.58** |
| G-phenyl-58 | 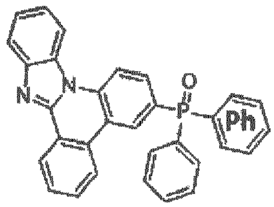 | -5.71 | -1.45 | **4.34** |
| G-phenyl-59 | 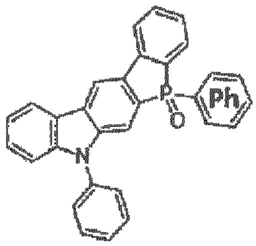 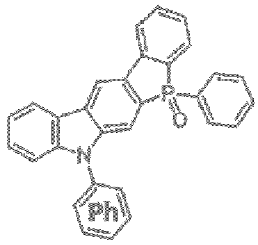 | -5.42 | -1.34 | **4.33** |
| G-phenyl-60 | 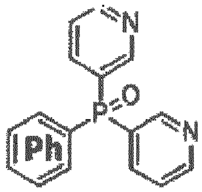 | -6.89 | -1.25 | **3.44** |
| G-phenyl-61 | 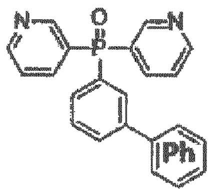 | -6.32 | -1.28 | **3.20** |

(continued)

| | Structure of G-phenyl | HOMO [eV] | LUMO [eV] | Dipole moment [D] |
|---|---|---|---|---|
| G-phenyl-62 | 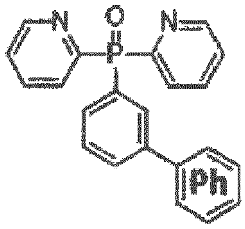 | -5.96 | -1.24 | **4.42** |
| G-phenyl-63 | 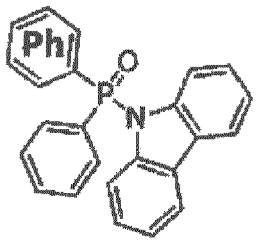 | -5.63 | -0.96 | **4.10** |
| G-phenyl-64 | 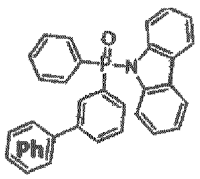 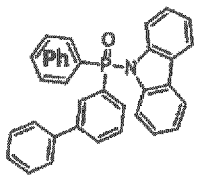 | -5.64 | -1.05 | **4.23** |
| G-phenyl-65 | 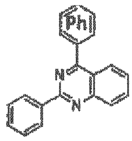 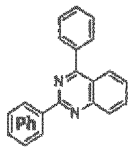 | -6.00 | -1.88 | **2.46** |
| G-phenyl-66 | 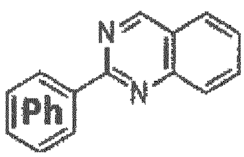 | -6.12 | -1.82 | **2.22** |
| G-phenyl-67 | 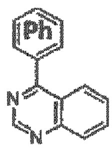 | -6.36 | -1.87 | **3.04** |

(continued)

| | Structure of G-phenyl | HOMO [eV] | LUMO [eV] | Dipole moment [D] |
|---|---|---|---|---|
| G-phenyl-68 | 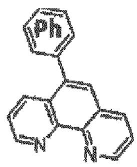 | -6.03 | -1.46 | **3.58** |
| G-phenyl-69 | 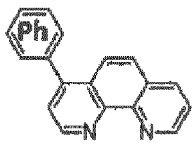 | -6.09 | -1.46 | **3.67** |
| G-phenyl-70 | 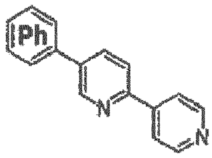 | -6.17 | -1.85 | **4.56** |
| G-phenyl-71 | 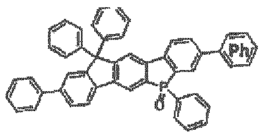 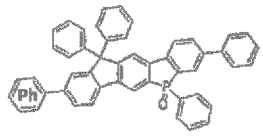 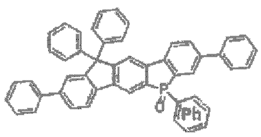 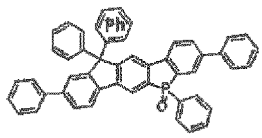 | -5.50 | -1.74 | **4.45** |
| G-phenyl-72 | 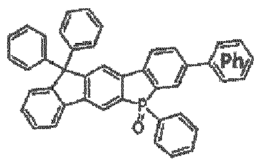 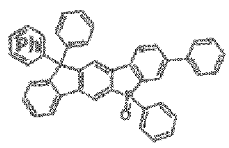 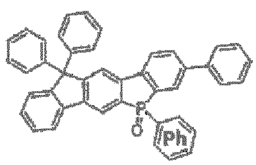 | -5.55 | -1.76 | **4.44** |
| G-phenyl-73 | 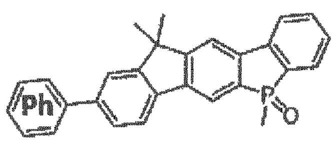 | -5.58 | -1.64 | **4.98** |

(continued)

| | Structure of G-phenyl | HOMO [eV] | LUMO [eV] | Dipole moment [D] |
|---|---|---|---|---|
| G-phenyl-74 | 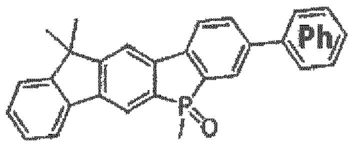 | -5.60 | -1.66 | **4.81** |
| G-phenyl-75 | 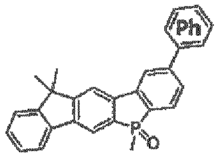 | -5.70 | -1.60 | **5.11** |
| G-phenyl-76 | 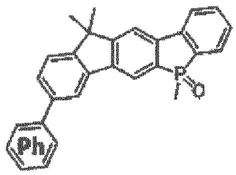 | -5.66 | -1.58 | **4.90** |
| G-phenyl-77 | 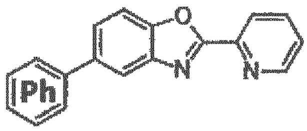 | -5.95 | -1.70 | **1.25** |
| G-phenyl-78 | 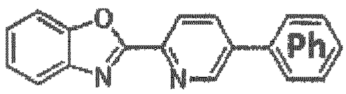 | -5.92 | -1.91 | **1.83** |
| G-phenyl-79 | 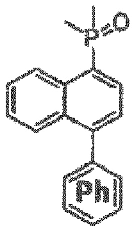 | -5.84 | -1.41 | **4.28** |
| G-phenyl-80 | 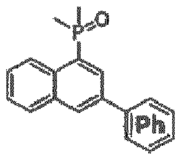 | -5.81 | -1.40 | **3.98** |

(continued)

| | Structure of G-phenyl | HOMO [eV] | LUMO [eV] | Dipole moment [D] |
|---|---|---|---|---|
| G-phenyl-81 | 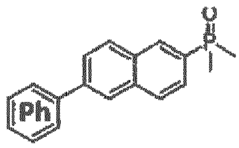 | -5.84 | -1.61 | **4.50** |
| G-phenyl-82 | 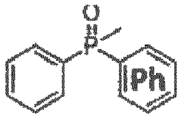 | -6.85 | -0.85 | **4.00** |
| G-phenyl-83 | 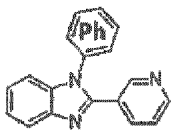 | -5.88 | -1.27 | **2.59** |
| G-phenyl-84 | 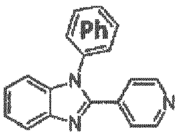 | -6.02 | -1.48 | **4.35** |

The EIL may be free of the compound comprising the group G. The EIL may be free of the compound of Formula (II).

In an alternative embodiment, the ETL comprises one or more electrical n-dopants, in particular, but not limited thereto, an elemental metal, alternatively an electropositive metal selected from alkali metals, alkaline earth metals, rare earth metals and transition metals, transition metals; a metal salt, alternatively an alkali metal salt, alkaline earth metal salt and/or rare earth metal salt, or a metal complex, alternatively an alkali metal complex, alkaline earth metal complex, transition metal complex and/or rare earth metal complex. Examples of n-doping metal salts can be LiF, LiCl, LiBr, LiI, metal borates, metal quinolinolates or mixtures thereof. Further examples of electrical n-dopants are strong chemical reducing agents. This class of "redox" n-dopants may be generically characterized by energy level of the highest occupied molecular orbital (HOMO) comparable with lowest unoccupied molecular orbital Energy Level of corresponding electron transport matrices, which is in usual OLED transport materials about -3.0 eV or less. It is to be understood that the term "about -3.0 eV or less" means less negative values than -3.0 eV, for example -2.8 eV, -2.5 eV, -2.3 eV, -2.1 eV or vales less negative than -2.0 eV.

Electrical n-dopants may be organic compounds as disclosed in EP1837926A1, WO07107306A1 or WO07107356A1.

The EIL may be in direct contact with a LiQ containing ETL.

Auxiliary electron transport layer

The organic light emitting diode may further comprise an auxiliary electron transport layer (a-ETL); and the auxiliary electron transport layer is arranged between the emission layer and the electron transport layer.

The auxiliary electron transport layer may be in direct contact with the emission layer.

The auxiliary electron transport layer may be in direct contact with the electron transport layer.

The auxiliary electron transport layer may comprise a compound of formula (III)

$(Ar^1-A_c)_a-X_b$ (III)

wherein

- a and b are independently 1 or 2;
- c is independently o or 1;
- $Ar^1$ is independently selected from $C_6$ to $C_{60}$ aryl or $C_2$ to $C_{42}$ heteroaryl,
  - wherein each $Ar^1$ may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
  - wherein each $C_6$ to $C_{12}$ aryl substituent on $Ar^1$ and each $C_3$ to $C_{11}$ heteroaryl substituent on $Ar^1$ may be substituted with $C_1$ to $C_4$ alkyl or halogen;
- A is independently selected from $C_6$ to $C_{30}$ aryl,
  - wherein each A may be substituted with one or two substituents independently selected from the group consisting of $C_6$ to $C_{12}$ aryl and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
  - wherein each $C_6$ to $C_{12}$ aryl substituent on A may be substituted with $C_1$ to $C_4$ alkyl or halogen;
- X is independently selected from the group consisting of $C_2$ to $C_{42}$ heteroaryl and $C_6$ to $C_{60}$ aryl,
  - wherein each X may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
  - wherein each $C_6$ to $C_{12}$ aryl substituent on X and each $C_3$ to $C_{11}$ heteroaryl substituent on X may be substituted with $C_1$ to $C_4$ alkyl or halogen; and
- the molecular dipole moment of the compound of formula (I) is ≥ o D and ≤ 4 D.

Exemplary compounds A-1 to A-8 of formula (III) are shown in Table 3:

Table 3:

| Name | Structure | HOMO [eV] | LUMO [eV] | Dipole moment [D] |
|---|---|---|---|---|
| A-1 | 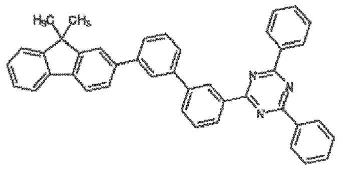 | -5.57 | -1.84 | 0.48 |
| A-2 | 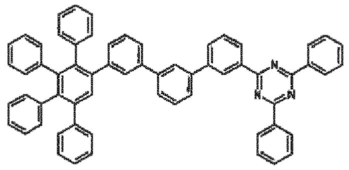 | -5.72 | -1.82 | 0.30 |
| A-3 | 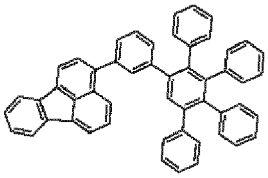 | -5.57 | -1.78 | 1.02 |
| A-4 | 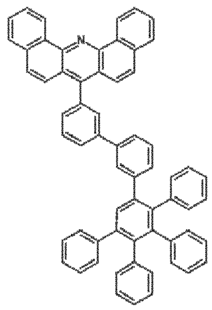 | -5.60 | -1.70 | 2.74 |
| A-5 | 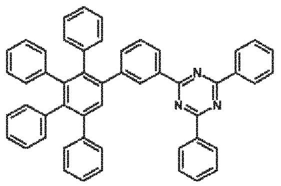 | -5.82 | -1.76 | 0.57 |
| A-6 | 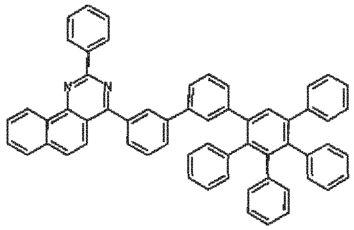 | -5.77 | -1.75 | 1.59 |

(continued)

| Name | Structure | HOMO [eV] | LUMO [eV] | Dipole moment [D] |
|---|---|---|---|---|
| A-7 | 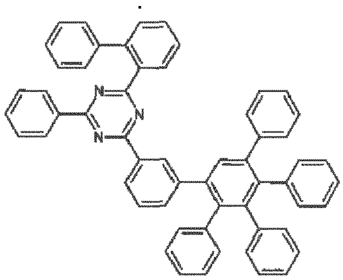 | -5.82 | -1.69 | 0.50 |
| A-8 | 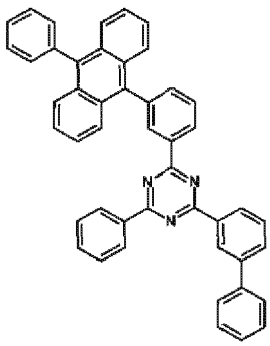 | -5.19 | -1.84 | 0.37 |

Further exemplary compounds of formula 3 are the following compounds A-9 to A-20

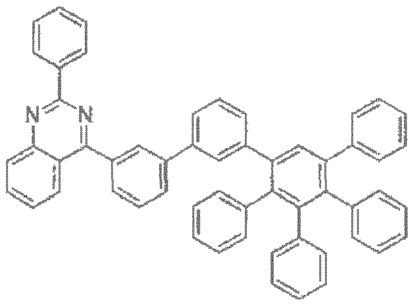

A-9

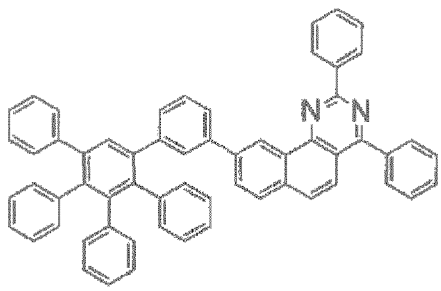

A-10

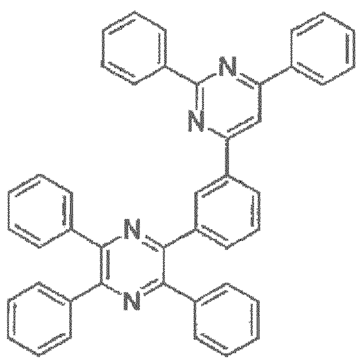

A-11

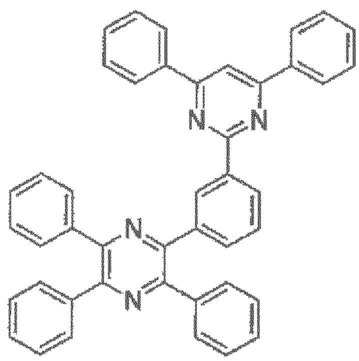

A-12

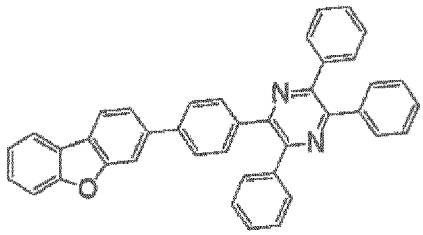

A-13

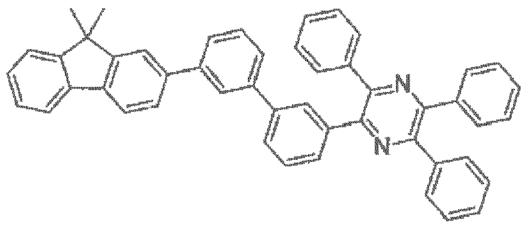

A-14

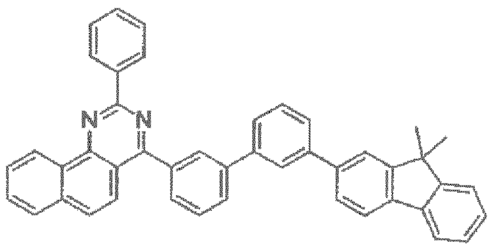

A-15

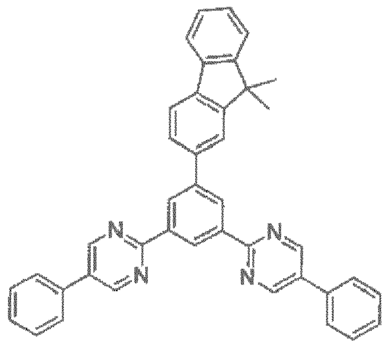

A-16

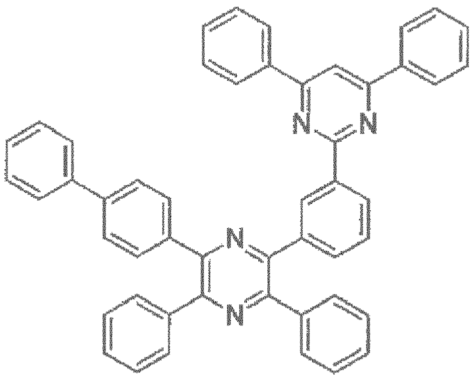

A-17

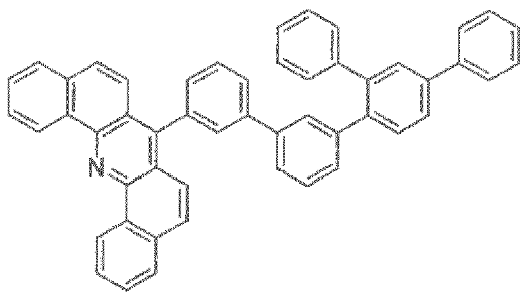

A-18

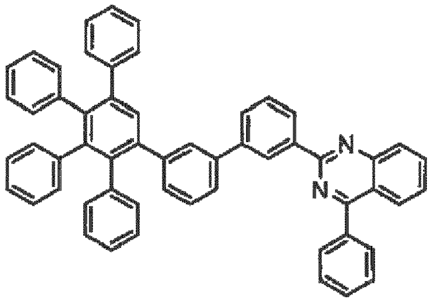

A-19

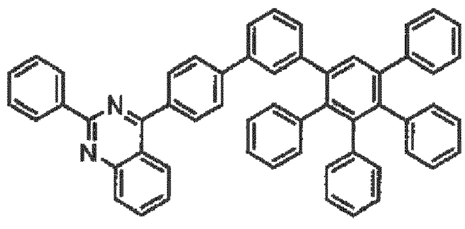

A-20

Exemplary embodiments

In one embodiment of the invention, there is provided an organic light emitting diode comprising a non-transparent substrate, an anode, a cathode, an emission layer, an electron injection layer, and an electron transport layer; wherein

- the emission layer, the electron injection layer and the electron transport layer are arranged between the anode and the cathode;
- the electron injection layer and the electron transport layer are arranged between the emission layer and the cathode;
- the electron injection layer is in direct contact to the electron transport layer;
- the electron injection layer is in direct contact to the cathode; and
- the electron injection layer consists of a compound of Formula (I) or of a mixture of two or more compounds of Formula (I)

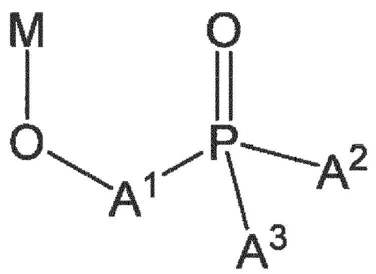

(I)

wherein

M is Li;

$A^1$ is selected from the group consisting of pyridinylene, quinolinylene, phenylene and naphtylene;

$A^1$ is unsubstituted or substituted with one or more substituents, preferably one substituent $PO(R^{10})_2$, wherein $R^{10}$ is independently selected from $C_6$ aryl or $C_5$ heteroaryl;

$A^2$ and $A^3$ are independently selected from phenyl and pyridinyl; and

$A^2$ and $A^3$ are independently unsubstituted or substituted with one substituent -O-Li.

In one embodiment of the invention, there is provided an organic light emitting diode comprising a non-transparent substrate, an anode, a cathode, an emission layer, an electron injection layer, and an electron transport layer; wherein

- the emission layer, the electron injection layer and the electron transport layer are arranged between the anode and the cathode;
- the electron injection layer and the electron transport layer are arranged between the emission layer and the cathode;
- the electron injection layer is in direct contact to the electron transport layer;
- the electron injection layer is in direct contact to the cathode; and
- the electron injection layer consists of a compound of Formula (I) or of a mixture of two or more compounds of Formula (I)

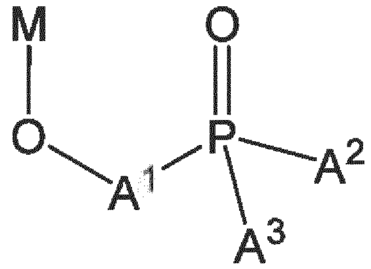

(I)

wherein

- M is an alkali metal;
- $A^1$ is selected from $C_6$ to $C_{60}$ arylene or $C_2$ to $C_{42}$ heteroarylene;
- $A^2$ and $A^3$ are independently selected from the group consisting of $C_6$ to $C_{30}$ aryl, $C_2$ to $C_{30}$ heteroaryl, and $C_1$ to $C_{16}$ alkyl;
- each $Ar^2$ to $Ar^5$ may independently be unsubstituted or substituted with one or more substituents independently selected from the group consisting of $C_6$ to $C_{12}$ aryl, $C_3$ to $C_{11}$ heteroaryl, $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, -O-Li; CN and $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$, to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $A^2$ and $A^3$ may be linked to each other;

wherein the cathode comprises a cathode sub-layer; the cathode sub-layer comprises a rare earth metal, preferably Yb; and the cathode sub-layer is in direct contact with the electron injection layer wherein the cathode sub-layer has a thickness from 0.5 nm to 5 nm.

In one embodiment of the invention, there is provided an organic light emitting diode comprising a non-transparent substrate, an anode, a cathode, an emission layer, an electron injection layer, and an electron transport layer; wherein

- the emission layer, the electron injection layer and the electron transport layer are arranged between the anode and the cathode;
- the electron injection layer and the electron transport layer are arranged between the emission layer and the cathode;
- the electron injection layer is in direct contact to the electron transport layer;
- the electron injection layer is in direct contact to the cathode; and
- the electron injection layer consists of a compound of Formula (I) or of a mixture of two or more compounds of Formula (I)

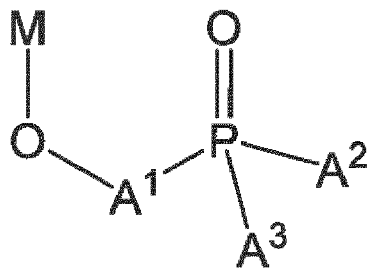

(I)

wherein

- M is an alkali metal;
- $A^1$ is selected from $C_6$ to $C_{60}$ arylene or $C_2$ to $C_{42}$ heteroarylene;
- $A^2$ and $A^3$ are independently selected from the group consisting of $C_6$ to $C_{30}$ aryl, $C_2$ to $C_{30}$ heteroaryl, and $C_1$ to $C_{16}$ alkyl;
- each $Ar^2$ to $Ar^5$ may independently be unsubstituted or substituted with one or more substituents independently selected from the group consisting of $C_6$ to $C_{12}$ aryl, $C_3$ to $C_{11}$ heteroaryl, $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, -O-Li; CN and $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $A^2$ and $A^3$ may be linked to each other;

wherein the electron transport layer is free of n-dopant; and
the electron transport layer comprises a compound of formula (II)

$$(Ar^2)_m\text{-}(Z_k\text{-}G)_n \qquad \text{(II)}$$

wherein $Ar^2$ Z and G are as defined above.

In one embodiment of the invention, there is provided an organic light emitting diode comprising a non-transparent substrate, an anode, a cathode, an emission layer, an electron injection layer, and an electron transport layer; wherein

- the emission layer, the electron injection layer and the electron transport layer are arranged between the anode and the cathode;
- the electron injection layer and the electron transport layer are arranged between the emission layer and the cathode;
- the electron injection layer is in direct contact to the electron transport layer;
- the electron injection layer is in direct contact to the cathode; and
- the electron injection layer consists of a compound of Formula (I) or of a mixture of two or more compounds of Formula (I)

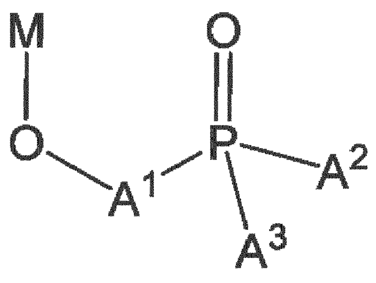
(I)

wherein

- M is an alkali metal;
- $A^1$ is selected from $C_6$ to $C_{60}$ arylene or $C_2$ to $C_{42}$ heteroarylene;

- $A^2$ and $A^3$ are independently selected from the group consisting of $C_6$ to $C_{30}$ aryl, $C_2$ to $C_{30}$ heteroaryl, and $C_1$ to $C_{16}$ alkyl;

- each $Ar^2$ to $Ar^5$ may independently be unsubstituted or substituted with one or more substituents independently selected from the group consisting of $C_6$ to $C_{12}$ aryl, $C_3$ to $C_{11}$ heteroaryl, $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, -O-Li; CN and $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $A^2$ and $A^3$ may be linked to each other;

wherein the organic light emitting diode further comprises an auxiliary electron transport layer; and the auxiliary electron transport layer is arranged between the emission layer and the electron transport layer, especially in direct contact with the emission layer and in direct contact with the electron transport layer.

In one embodiment of the invention, there is provided an organic light emitting diode comprising a non-transparent substrate, an anode, a cathode, an emission layer, an electron injection layer, and an electron transport layer; wherein

- the emission layer, the electron injection layer and the electron transport layer are arranged between the anode and the cathode;

- the electron injection layer and the electron transport layer are arranged between the emission layer and the cathode;

- the electron injection layer is in direct contact to the electron transport layer;

- the electron injection layer is in direct contact to the cathode; and

- the electron injection layer consists of a compound of Formula (I) or of a mixture of two or more compounds of Formula (I)

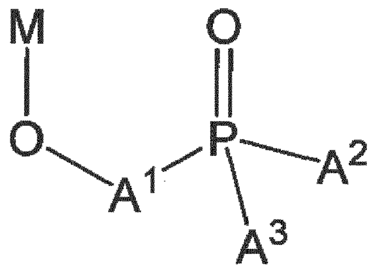

(I)

wherein

- M is an alkali metal;

- $A^1$ is selected from $C_6$ to $C_{60}$ arylene or $C_2$ to $C_{42}$ heteroarylene;

- $A^2$ and $A^3$ are independently selected from the group consisting of $C_6$ to $C_{30}$ aryl, $C_2$ to $C_{30}$ heteroaryl, and $C_1$ to $C_{16}$ alkyl;

- each $Ar^2$ to $Ar^5$ may independently be unsubstituted or substituted with one or more substituents independently selected from the group consisting of $C_6$ to $C_{12}$ aryl, $C_3$ to $C_{11}$ heteroaryl, $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, -O-Li; CN and $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially

or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $A^2$ and $A^3$ may be linked to each other;

wherein the cathode comprises a cathode sub-layer; the cathode sub-layer comprises a rare earth metal, preferably Yb; and the cathode sub-layer is in direct contact with the electron injection layer wherein the cathode sub-layer has a thickness from 0.5 nm to 5 nm;

wherein the electron transport layer is free of n-dopant; and

the electron transport layer comprises a compound of formula (II)

$$(Ar^2)_m\text{-}(Z_k\text{-}G)_n \qquad \text{(II)}$$

wherein $Ar^2$ Z and G are as defined above; and

wherein the organic light emitting diode further comprises an auxiliary electron transport layer; and the auxiliary electron transport layer is arranged between the emission layer and the electron transport layer, especially in direct contact with the emission layer and in direct contact with the electron transport layer.

In one embodiment of the invention, there is provided an organic light emitting diode comprising a non-transparent substrate, an anode, a cathode, an emission layer, an electron injection layer, and an electron transport layer; wherein

- the emission layer, the electron injection layer and the electron transport layer are arranged between the anode and the cathode;
- the electron injection layer and the electron transport layer are arranged between the emission layer and the cathode;
- the electron injection layer is in direct contact to the electron transport layer;
- the electron injection layer is in direct contact to the cathode; and
- the electron injection layer consists of a compound of Formula (I) or of a mixture of two or more compounds of Formula (I)

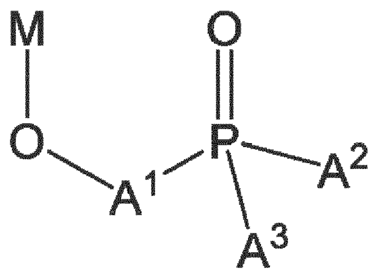

(I)

wherein

- M is an alkali metal;
- $A^1$ is selected from $C_6$ to $C_{60}$ arylene or $C_2$ to $C_{42}$ heteroarylene;
- $A^2$ and $A^3$ are independently selected from the group consisting of $C_6$ to $C_{30}$ aryl, $C_2$ to $C_{30}$ heteroaryl, and $C_1$ to $C_{16}$ alkyl;
- each $Ar^2$ to $Ar^5$ may independently be unsubstituted or substituted with one or more substituents independently selected from the group consisting of $C_6$ to $C_{12}$ aryl, $C_3$ to $C_{11}$ heteroaryl, $C_1$ to $C_6$ alkyl, D, $C_1$ to $C_6$ alkoxy, $C_3$ to

$C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, -O-Li; CN and $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $A^2$ and $A^3$ may be linked to each other;

wherein the cathode comprises a cathode sub-layer; the cathode sub-layer comprises a rare earth metal, preferably Yb; and the cathode sub-layer is in direct contact with the electron injection layer wherein the cathode sub-layer has a thickness from 0.5 nm to 5 nm;

wherein the electron transport layer is free of n-dopant; and

the electron transport layer comprises a compound of formula (II)

$$(Ar^2)m\text{-}(Z_k\text{-}G)_n \qquad \text{(II)}$$

wherein $Ar^2$, m, Z, k, G, and n are as defined above;

wherein the organic light emitting diode further comprises an auxiliary electron transport layer; and the auxiliary electron transport layer is arranged between the emission layer and the electron transport layer, especially in direct contact with the emission layer and in direct contact with the electron transport layer; and

wherein the auxiliary electron transport layer comprises a compound of formula (III)

$$(Ar^1\text{-}A_c)_a\text{-}X_b \qquad \text{(III)}$$

wherein $Ar^1$, c, A, a, X, and b are as defined above.

Further layers

In accordance with the invention, the organic electronic device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. Light is to be emitted through the top surface and the substrate is a non-transparent material, for example a plastic substrate, a metal substrate or a silicon substrate.

*Anode electrode*

Either a first electrode or a second electrode comprised in the inventive organic electronic device may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode electrode may also be formed using metals, typically silver (Ag), gold (Au), or metal alloys. The transparent or semitransparent anode may facilitate light emission through the anode.

*Hole injection layer*

A hole injection layer (HIL) maybe formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure

and thermal properties of the HIL. In general, however, conditions for vacuum deposition may include a deposition temperature of 100° C to 500° C, a pressure of 10-8 to 10-3 Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene)-dimalononitrile, 4,4',4"-((1E,1'E,1"E)-cyclopropane-1,2,3-triylidenetris(cyanomethanylylidene))tris(2,3,5,6-tetrafluorobenzonitrile) or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Emission layer (EML)*

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the compound of Formulas (I), (II) and/or the compound (III).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and $Ir(dfppz)_3$ and ter-fluorene. 4.4'-bis(4-diphenylamiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function. The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The OLED according to the present invention may comprise an electron transport layer (ETL).

According to various embodiments the OLED may comprise an electron transport layer or an electron transport layer stack comprising at least a first electron transport layer and at least a second electron transport layer.

By suitably adjusting energy levels of particular layers of the ETL, the injection and transport of the electrons may be controlled, and the holes may be efficiently blocked. Thus, the OLED may have long lifetime.

The electron transport layer may comprise suitable ETM materials known in the art. In accordance with the invention, the electron transport layer may comprise, besides the ETM material, at least one additive as defined herein.

Further, the electron transport layer may (or may not) comprise one or more n-type dopants. The additive may be an n-type dopant. The additive can be alkali metal, alkali metal compound, alkaline earth metal, alkaline earth metal compound, transition metal, transition metal compound or a rare earth metal. In another embodiment, the metal can be

one selected from a group consisting of Li, Na, K, Rb, Cs, Mg, Ca, Sr, Ba, La, Ce, Sm, Eu, Tb, Dy, and Yb. In another embodiment, the n-type dopant can be one selected from a group consisting of Cs, K, Rb, Mg, Na, Ca, Sr, Eu and Yb. In an embodiment the alkali metal compound may be 8-Hydroxyquinolinolato-lithium (LiQ), Lithium tetra(1H-pyrazol-1-yl)borate or Lithium 2-(diphenylphosphoryl)phenolate. Suitable compounds for the ETM are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

The compound of formula (I) may not be comprised in the electron transport layer.

*Electron injection layer (EIL)*

The electronic device comprises an EIL as defined herein.

In addition to the compound of Formula (I) the EIL may contain one or more further common EIL materials.

The EIL may be free of Yb.

The EIL may be free of LiQ.

The EIL may be free of Ag, Mg, Al, and LiF.

Deposition and coating conditions for forming the EIL are similar to those for formation of the HIL, although the deposition and coating conditions may vary, according to the material that is used to form the EIL. The EIL may comprise an organic matrix material doped with an n-type dopant. The matrix material may be selected from materials conventionally used as matrix materials for electron transport layers.

The EIL may consist of a number of individual EIL sublayers. In case the EIL consists of a number of individual EIL sublayers, the number of sublayers is preferably 2. The individual EIL sublayers may comprise different materials for forming the EIL.

The thickness of the EIL may be in the range from about 0.1 nm to about 10 nm, for example, in the range from about 0.5 nm to about 9 nm, further from about 0.5 nm to about 5 nm. When the thickness of the EIL is within this range, the EIL may have satisfactory electron-injecting properties, without a substantial penalty in driving voltage.

The electron transport layer or a sub-layer thereof may not be part of the electron injection layer.

*Cathode electrode*

The cathode electrode is formed on the EIL if present, preferably directly on the EIL, preferably in direct contact with the EIL. In the sense of this invention the cathode and the EIL can be regarded as one functional part enabling the injection of electrons into the electron transport layer stack. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode electrode maybe in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy. The transparent or semitransparent cathode may facilitate light emission through the cathode.

It is to be understood that the cathode electrode is not part of the electron injection layer.

*Charge generation layer*

A charge generation layer (CGL) may be comprised in the inventive OLED. This layer may comprise a p-type CGL and an n-type CGL. An interlayer may be arranged between the p-type layer and the n-type layer.

Typically, the charge generation layer GCL is a pn-junction joining an n-type charge generation layer (electron generating layer, n-type CGL) and a-type charge generation layer (hole generating layer, p-type CGL). The n-side of the pn-junction generates electrons and injects them into the layer which is adjacent in the direction to the anode. Analogously, the p-side of the pn-junction generates holes and injects them into the layer which is adjacent in the direction to the cathode.

Charge generation layers are used in tandem OLEDs comprising, between the cathode and anode, two or more emission layers. In a tandem OLED comprising two emission layers, the n-type charge generation layer provides electrons for the first light emission layer arranged near the anode, while the hole generating layer provides holes to the second light emission layer arranged between the first emission layer and the cathode.

Suitable matrix materials for the hole generating layer may be materials conventionally used as hole injection

and/or hole transport matrix materials. Also, p-type dopant used for the hole generating layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl3, FeF3, and SbCl5. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB). The p-type charge generation layer may consist of CNHAT.

The n-type charge generation layer may be layer of a neat n-type dopant, for example of an electropositive metal, or can consist of an organic matrix material doped with the n-type dopant. In one embodiment, the n-type dopant can be alkali metal, alkali metal compound, alkaline earth metal, alkaline earth metal compound, a transition metal, a transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the n-type charge generation layer layer may be the materials conventionally used as matrix materials for electron injection or electron transport layers. The matrix material can be for example one selected from a group consisting of N-containing heterocyclic compounds like triazine compounds or phenathroline compounds such as compound E or bipyridyl or terpyridyl compounds, hydroxyquinoline derivatives like tris(8-hydroxyquinoline)aluminum, benzazole derivatives, and silole derivatives.

Organic light-emitting diode (OLED)

According to one aspect of the present invention, there is provided an organic light-emitting diode (OLED) comprising: a substrate; an anode electrode formed on the substrate; a hole injection layer, a hole transport layer, an emission layer, an electron transport layer, the electro injection layer and a cathode electrode.

According to one aspect of the present invention, there is provided an organic light-emitting diode (OLED) comprising: a substrate; an anode electrode formed on the substrate; a hole injection layer, a hole transport layer, an electron blocking layer, an emission layer, an electron transport layer, the electron injection layer and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, an electron transport layer, the electron injection layer and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, an electron transport layer, an electron injection layer, and a cathode electrode.

According to various embodiments of the present invention, there may be provided OLEDs layers arranged between the above mentioned layers, on the substrate or on the top electrode.

According to one aspect, the OLED can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to an electron transport layer, which may optionally be formed by two sub-layer, which are a first electron transport layer and a second electron transport layer, the first electron transport layer is adjacent arranged to a second electron transport layer, the second electron transport layer is adjacent arranged to an electron injection layer, the electron injection layer is adjacent arranged to the cathode electrode.

For example, the OLED (100) according to Fig. 1 may be formed by a process, wherein on a substrate (110), an anode (120), a hole injection layer (130), a hole transport layer (140), an emission layer (150), an electron transport layer (160) comprising as two sub-layers a first electron transport layer (=aETL) (161) and a second electron transport layer (162), an electron injection layer (180) and the cathode electrode (190) are subsequently formed in that order.

For example, the OLED (100) according to Fig. 2 may be formed by a process, wherein on a substrate (110), an anode (120), a hole injection layer (130), a hole transport layer (140), an electron blocking layer (145), an emission layer (150), an electron transport layer (160) comprising as two sub-layers a first electron transport layer (=aETL) (161) and a second electron transport layer (162), an electron injection layer (180) and the cathode electrode (190) are subsequently formed in that order.

For example, the OLED (100) according to Fig. 3 may be formed by a process, wherein on a substrate (110), a multilayer anode 120, the multilayer anode 120 comprising a first anode sub-layer 121, a second anode sub-layer 122, and a third anode sub-layer 123, a hole injection layer (130), a hole transport layer (140), an emission layer (150), an electron transport layer stack (160) comprising as two sub-layers a first electron transport layer (=aETL) (161) and a second electron transport layer (162), an electron injection layer (180) and the cathode electrode (190) are subsequently formed in that order.

For example, the OLED according to Fig. 4 may be formed by a process, wherein on a substrate 110, an anode

120, a first hole injection layer 130, a first hole transport layer 140, a first electron blocking layer 145, a first emission layer 150, a first electron transport layer stack 160, an n-type charge generation layer 185, a hole generating layer 135, a second hole transport layer 141, a second electron blocking layer 146, a second emission layer 151, a second electron transport layer stack 165, a second electron injection layer 181 and a cathode 190 are subsequently formed in that order.

According to another aspect of the present invention, there is provided a method of manufacturing an organic electronic device, the method using:

at least one deposition source, preferably two deposition sources and more preferred at least three deposition sources.

The methods for deposition that can be suitable comprise:

- deposition via vacuum thermal evaporation;
- deposition via solution processing, preferably the processing is selected from spin-coating, printing, casting; and/or
- slot-die coating.

According to various embodiments of the present invention, the method may further include forming on the anode electrode, an emission layer and at least one layer selected from the group consisting of forming a hole injection layer, forming a hole transport layer, or forming an electron hole blocking layer, between the anode electrode and the first electron transport layer.

According to various embodiments of the present invention, the method may further include the steps for forming an organic light-emitting diode (OLED), wherein

- on a substrate a first anode electrode is formed,
- on the first anode electrode an emission layer is formed,
- on the emission layer an electron transport layer stack is formed, optionally a hole blocking layer is formed on the emission layer and on the electron transport layer an electro injection layer is formed,
- and finally a cathode electrode is formed,
- optional a hole injection layer, a hole transport layer, and a hole blocking layer, formed in that order between the first anode electrode and the emission layer,
- an electron injection layer is formed between the electron transport layer stack and the cathode electrode.

The method comprises forming an electron injection layer on the organic semiconducting layer. According to various embodiments, the OLED may have the following layer structure, wherein the layers having the following order: anode, hole injection layer, first hole transport layer, second hole transport layer, emission layer, optional hole blocking layer, an electron transport layer, the electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

In one embodiment, the organic electronic device according to the invention may further comprise a layer comprising a radialene compound and/or a quinodimethane compound.

In one embodiment, the radialene compound and/or the quinodimethane compound may be substituted with one or more halogen atoms and/or with one or more electron withdrawing groups. Electron withdrawing groups can be selected from nitrile groups, halogenated alkyl groups, alternatively from perhalogenated alkyl groups, alternatively from perfluorinated alkyl groups. Other examples of electron withdrawing groups may be acyl, sulfonyl groups or phosphoryl groups.

Alternatively, acyl groups, sulfonyl groups and/or phosphoryl groups may comprise halogenated and/or perhalogenated hydrocarbyl. In one embodiment, the perhalogenated hydrocarbyl may be a perfluorinated hydrocarbyl. Examples of a perfluorinated hydrocarbyl can be perfluormethyl, perfluorethyl, perfluorpropyl, perfluorisopropyl, perfluorobutyl, perfluorophenyl, perfluorotolyl; examples of sulfonyl groups comprising a halogenated hydrocarbyl may be

trifluoromethylsulfonyl, pentafluoroethylsulfonyl, pentafluorophenylsulfonyl, heptafluoropropylsufonyl, nonafluorobutylsulfonyl, and like.

In one embodiment, the radialene and/or the quinodimethane compound may be comprised in a hole injection, hole transporting and/or a hole generation layer.

In one embodiment, the radialene compound may have Formula (XX) and/or the quinodimethane compound may have Formula (XXIa) or (XXIb):

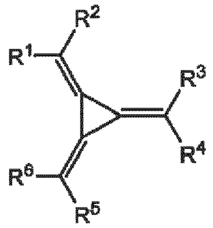 (XX) 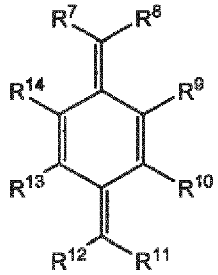 (XXIa) 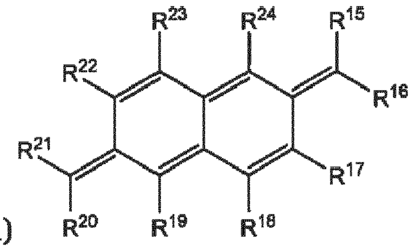 (XXIb),

wherein $R^1$, $R^2$, $R^3$, $R^4$, $R^5$, $R^6$, $R^7$, $R^8$, $R^{11}$, $R^{12}$, $R^{15}$, $R^{16}$, $R^{20}$, $R^{21}$ are independently selected from above mentioned electron withdrawing groups and $R^9$, $R^{10}$, $R^{13}$, $R^{14}$, $R^{17}$, $R^{18}$, $R^{19}$, $R^{22}$, $R^{23}$ and $R^{24}$ are independently selected from H, halogen and above mentioned electron withdrawing groups.

Hereinafter, the embodiments are illustrated in more detail with reference to examples. However, the present disclosure is not limited to the following examples. Reference will now be made in detail to the exemplary aspects.

GENERAL DEFINITIONS

In the present specification, when a definition is not otherwise provided, an "alkyl group" may refer to an aliphatic hydrocarbon group. The alkyl group may refer to "a saturated alkyl group" without any double bond or triple bond. The term "alkyl" as used herein shall encompass linear as well as branched and cyclic alkyl. For example, $C_3$-alkyl may be selected from n-propyl and iso-propyl. Likewise, $C_4$-alkyl encompasses n-butyl, sec-butyl and t-butyl. Likewise, $C_6$-alkyl encompasses n-hexyl and cyclo-hexyl.

As used herein if not explicitly mentioned else, the asterisk symbol "*" represents a binding position at which the moiety labelled accordingly is bond to another moiety.

The subscribed number n in $C_n$ relates to the total number of carbon atoms in the respective alkyl, arylene, heteroarylene or aryl group.

The term "aryl" or "arylene" as used herein shall encompass phenyl ($C_6$-aryl), fused aromatics, such as naphthalene, anthracene, phenanthrene, tetracene etc.. Further encompassed are biphenyl and oligo- or polyphenyls, such as terphenyl, phenyl-substituted biphenyl, phenyl-substituted terphenyl (such as tetraphenyl benzole groups) etc.. "Arylene" respectively "heteroarylene", refers to groups to which two further moieties are attached. In the present specification, the term "aryl group" or "arylene group" may refer to a group comprising at least one hydrocarbon aromatic moiety, and all the elements of the hydrocarbon aromatic moiety may have p-orbitals which form conjugation, for example a phenyl group, a napthyl group, an anthracenyl group, a phenanthrenyl group, a pyrinyl group, a fluorenyl group and the like. Further encompoassed are spiro compounds in which two aromatic moieties are connected with each other via a spiro-atom, such as 9,9'-spirobi[9H-fluorene]yl. The aryl or arylene group may include a monocyclic or fused ring polycyclic (i.e., links sharing adjacent pairs of carbon atoms) functional group.

The term "heteroaryl" as used herein refers to aryl groups in which at least one carbon atom is substituted with a heteroatom. The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S. A heteroarylene ring may comprise at least 1 to 3 heteroatoms. Preferably, a heteroarylene ring may comprise at least 1 to 3 heteroatoms individually selected from N, S and/or O. Just as in case of "aryl"/"arylene", the term "heteroaryl" comprises, for example, spiro compounds in which two aromatic moieties are connected with each other, such as spiro[fluorene-9,9'-xanthene]. Further exemplary heteroaryl groups are diazine, triazine, dibenzofurane, dibenzothiofurane, acridine, benzoacridine, dibenzoacridine etc.

The term "alkenyl" as used herein refers to a group $-CR^1 = CR^2R^3$ comprising a carbon-carbon double bond.

The term "perhalogenated" as used herein refers to a hydrocarbyl group wherein all of the hydrogen atoms of the hydrocarbyl group are replaced by halogen (F, Cl, Br, I) atoms.

The term "alkoxy" as used herein refers to a structural fragment of the Formula -OR with R being hydrocarbyl, preferably alkyl or cycloalkyl.

The term "thioalkyl" as used herein refers to a structural fragment of the Formula -SR with R being hydrocarbyl, preferably alkyl or cycloalkyl.

The subscripted number n in Cn-heteroaryl merely refers to the number of carbon atoms excluding the number of heteroatoms. In this context, it is clear that a $C_3$ heteroarylene group is an aromatic compound comprising three carbon atoms, such as pyrazol, imidazole, oxazole, thiazole and the like.

The term "heteroaryl" as used herewith shall encompass pyridine, quinoline, benzoquinoline, quinazoline, benzoquinazoline, pyrimidine, pyrazine, triazine, benzimidazole, benzothiazole, benzo[4,5]thieno[3,2-d]pyrimidine, carbazole, xanthene, phenoxazine, benzoacridine, dibenzoacridine and the like.

In the present specification, the term single bond refers to a direct bond.

The term "fluorinated" as used herein refers to a hydrocarbon group in which at least one of the hydrogen atoms comprised in the hydrocarbon group is substituted by a fluorine atom. Fluorinated groups in which all of the hydrogen atoms thereof are substituted by fluorine atoms are referred to as perfluorinated groups and are particularly addressed by the term "fluorinated".

In terms of the invention, a group is "substituted with" another group if one of the hydrogen atoms comprised in this group is replaced by another group, wherein the other group is the substituent.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

The term "contacting sandwiched" refers to an arrangement of three layers whereby the layer in the middle is in direct contact with the two adjacent layers.

With respect to the inventive electron transport layer stack the compounds mentioned in the experimental part are most preferred.

A lighting device may be any of the devices used for illumination, irradiation, signaling, or projection. They are correspondingly classified as illuminating, irradiating, signaling, and projecting devices. A lighting device usually consists of a source of optical radiation, a device that transmits the radiant flux into space in the desired direction, and a housing that joins the parts into a single device and protects the radiation source and light-transmitting system against damage and the effects of the surroundings.

Another aspect is directed to a device comprising at least one organic electroluminescent device (OLED).

A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural Formula.

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", "percent by weight", "% by weight", and variations thereof refer to a composition, component, substance or agent as the weight of that component, substance or agent of the respective electron transport layer divided by the total weight of the respective electron transport layer thereof and multiplied by 100. It is under-stood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of', "does not contain", "does not comprise" does not exclude impurities. Likewise, a layer "consisting of" a certain material may comprise impurities, which cannot be avoided by conventional technical means. Impurities have no technical effect with respect to the object achieved by the present invention.

In the context of the present specification the term "essentially non-emissive" or "non-emissive" means that the contribution of the compound or layer to the visible emission spectrum from the device is less than 10 %, preferably

less than 5 % relative to the visible emission spectrum. The visible emission spectrum is an emission spectrum with a wavelength of about ≥ 380 nm to about ≤ 780 nm.

Preferably, the organic semiconducting layer comprising the compound of Formula (I) is essentially non-emissive or non-emitting.

The operating voltage, also named V, is measured in Volt (V) at 10 milliAmpere per square centimeter (mA/cm2).

The candela per Ampere efficiency, also named cd/A efficiency is measured in candela per ampere at 10 milliAmpere per square centimeter (mA/cm2).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color. Efficiency values are compared at the same CIE-y.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "life-span" and "lifetime" are simultaneously used and have the same meaning.

The anode and cathode may be described as anode electrode / cathode electrode or anode electrode / cathode electrode or anode electrode layer / cathode electrode layer.

Room temperature, also named ambient temperature, is 23° C.

## BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:

FIG. 1 is a schematic sectional view of an organic light-emitting diode (OLED), according to an exemplary embodiment of the present invention;

FIG. 2 is a schematic sectional view of an OLED, according to an exemplary embodiment of the present invention.

FIG. 3 is a schematic sectional view of a tandem OLED comprising a charge generation layer, according to an exemplary embodiment of the present invention.

FIG. 4 is a schematic sectional view of an organic light-emitting diode (OLED), according to an exemplary embodiment of the present invention.

## DETAILED DESCRIPTION

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic light-emitting diode (OLED) 100, according to an exemplary embodiment of the present invention. The OLED 100 includes a substrate 110, an anode 120, a hole injection layer (HIL) 130, a hole transport layer (HTL) 140, an emission layer (EML) 150, an electron transport layer (ETL) 160. The electron transport layer (ETL) 160 is formed on the EML 150. Onto the electron transport layer (ETL) 160, an electron injection layer (EIL) 180 is disposed. The cathode 190 is disposed directly onto the electron injection layer (EIL) 180.

Instead of a single electron transport layer 160, optionally an electron transport layer stack (ETL) can be used.

Fig. 2 is a schematic sectional view of an OLED 100, according to another exemplary embodiment of the present invention. Fig. 2 differs from Fig. 1 in that the OLED 100 of Fig. 2 comprises an electron blocking layer (EBL) 145 and a hole blocking layer (HBL) 155.

Referring to Fig. 2, the OLED 100 includes a substrate 110, an anode 120, a hole injection layer (HIL) 130, a hole transport layer (HTL) 140, an electron blocking layer (EBL) 145, an emission layer (EML) 150, a hole blocking layer

(HBL) 155, an electron transport layer (ETL) 160, an electron injection layer (EIL) 180 and a cathode electrode 190.

Fig. 3 is a schematic sectional view of a tandem OLED 200, according to another exemplary embodiment of the present invention. Fig. 3 differs from Fig. 2 in that the OLED 200 of Fig. 3 further comprises a charge generation layer (CGL) and a second emission layer (151).

Referring to Fig. 3, the OLED 200 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a second electron transport layer (ETL) 161, a second electron injection layer (EIL) 181 and a cathode 190.

FIG. 4 is a schematic sectional view of an organic light-emitting diode (OLED) 100, according to an exemplary embodiment of the present invention. The OLED 100 includes a non-transparent substrate 110, an anode 120, a hole injection layer (HIL) 130, a hole transport layer (HTL) 140, an emission layer (EML) 150, an electron transport layer (ETL) stack 160 comprising a first electron transport layer 161 and a second electron transport layer 162. The electron transport layer (ETL) 160 is formed on the EML 150. Onto the electron transport layer (ETL) 160, an electron injection layer (EIL) 180 is disposed. The cathode 190 is disposed directly onto the electron injection layer (EIL) 180.

While not shown in Figs. 1 to 4, a sealing layer may further be formed on the cathode electrodes 190, in order to seal the OLEDs 100 and 200. In addition, various other modifications may be applied thereto.

Hereinafter, the embodiments are illustrated in more detail with reference to examples. However, the present disclosure is not limited to the following examples. Reference will now be made in detail to the exemplary aspects.

Melting point

The melting point (mp) is determined as peak temperatures from the DSC curves of the above TGA-DSC measurement or from separate DSC measurements (Mettler Toledo DSC822e, heating of samples from room temperature to completeness of melting with heating rate 10 K/min under a stream of pure nitrogen. Sample amounts of 4 to 6 mg are placed in a 40 μL Mettler Toledo aluminum pan with lid, a <1 mm hole is pierced into the lid).

Glass transition temperature

The glass transition temperature (Tg) is measured under nitrogen and using a heating rate of 10 K per min in a Mettler Toledo DSC 822e differential scanning calorimeter as described in DIN EN ISO 11357, published in March 2010.

Rate onset temperature

The rate onset temperature (TRO) is determined by loading 100 mg compound into a VTE source. As VTE source a point source for organic materials may be used as supplied by Kurt J. Lesker Company (www.lesker.com) or CreaPhys GmbH (http://www.creaphys.com). The VTE source is heated at a constant rate of 15 K/min at a pressure of less than $10^{-5}$ mbar and the temperature inside the source measured with a thermocouple. Evaporation of the compound is detected with a QCM detector which detects deposition of the compound on the quartz crystal of the detector. The deposition rate on the quartz crystal is measured in Angstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of an organic compound, the rate onset temperature may be in the range of 200 to 255 °C. If the rate onset temperature is below 200 °C the evaporation may be too rapid and therefore difficult to control. If the rate onset temperature is above 255 °C the evaporation rate may be too low which may result in low tact time and decomposition of the organic compound in VTE source may occur due to prolonged exposure to elevated temperatures.

The rate onset temperature is an indirect measure of the volatility of a compound. The higher the rate onset temperature the lower is the volatility of a compound.

Reduction potential

The reduction potential is determined by cyclic voltammetry with potenioststic device Metrohm PGSTAT30 and software Metrohm Autolab GPES at room temperature. The redox potentials given at particular compounds were measured in an argon de-aerated, dry 0.1M THF solution of the tested substance, under argon atmosphere, with 0.1M tetrabutylammonium hexafluorophosphate supporting electrolyte, between platinum working electrodes and with an

Ag/AgCl pseudo-standard electrode (Metrohm Silver rod electrode), consisting of a silver wire covered by silver chloride and immersed directly in the measured solution, with the scan rate 100 mV/s. The first run was done in the broadest range of the potential set on the working electrodes, and the range was then adjusted within subsequent runs appropriately. The final three runs were done with the addition of ferrocene (in 0.1M concentration) as the standard. The average of potentials corresponding to cathodic and anodic peak of the studied compound, after subtraction of the average of cathodic and anodic potentials observed for the standard Fc+/Fc redox couple, afforded finally the values reported above. All studied compounds as well as the reported comparative compounds showed well-defined reversible electrochemical behavior.

Dipole moment

The dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule.

The dipole moment is determined by a semi-empirical molecular orbital method.

The geometries of the molecular structures are optimized using the hybrid functional B3LYP with the 6-31G* basis set in the gas phase as implemented in the program package TURBOMOLE V6.5 (TURBOMOLE GmbH, Litzenhardtstrasse 19, 76135 Karlsruhe, Germany). If more than one conformation is viable, the conformation with the lowest total energy is selected to determine the bond lengths of the molecules.

Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

Measurement of OLED Performance

To assess the performance of the OLED devices the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between oV and 10V. Likewise, the luminance-voltage characteristics and CIE coordinates are determined by measuring the luminance in cd/m$^2$ using an Instrument Systems CAS-140CT array spectrometer (calibrated by Deutsche Akkreditierungsstelle (DAkkS)) for each of the voltage values. The cd/A efficiency at 10 mA/cm$^2$ is determined by interpolating the luminance-voltage and current-voltage characteristics, respectively.

As applicable, Lifetime LT of the device can be measured at ambient conditions (20°C) and 30 mA/cm$^2$, using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operating voltage stability of the device. This increase is determined during the LT measurement and by subtracting the operating voltage at the start of operation of the device from the operating voltage after 50 hours.

$$\Delta U = [U(50\,h)-U(0\,h)]$$

The smaller the value of ΔU the better is the operating voltage stability.Synthesis procedure for preparing

compounds of formula (I)

All reactions were performed under inert atmosphere. Commercial reactants and reagents were used without further purification. Reaction solvents tetrahydrofurane (THF), acetonitrile (AcN) and dichloromethane (DCM) were dried by a solvent purification system (SPS).

Synthesis of lithium 2-(diphenylphosphoryl)pyridin-3-olate (ND-1)

*Step 1: diphenyl(pyridin-2-yl)phosphine oxide*

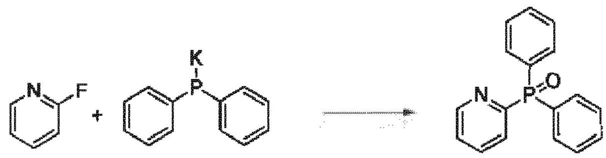

| | |
|---|---|
| 2-fluoropyridine | 2.50 g, 1.0 eq, 25.8 mmol |
| potassium diphenylphosphide | 51.5 mL, 1.0 eq, 25.8 mmol |
| THF | 50 mL |
| DCM | 80 mL |
| hydrogen peroxide | 25 mL |
| hexane | 20 mL |

Fluoropyridine was dissolved in dry THF. The potassium diphenylphosphide solution was added drop wise during one hour at room temperature. The resulting orange solution was stirred overnight at room temperature. The solvent was removed under reduced pressure and the residue dissolved in dichloromethane. Hydrogen peroxide was added slowly at o°C. The mixture was stirred overnight at room temperature. The solvent was removed under reduced pressure and the residue treated with hexane. The resulting solid was filtered off, washed with hexane and dried in vacuum.

Yield: 2.2 g (31 %), HPLC-MS purity 98.0 %.

*Step 2: (3-hydroxypyridin-2-yl)diphenylphosphine oxide*

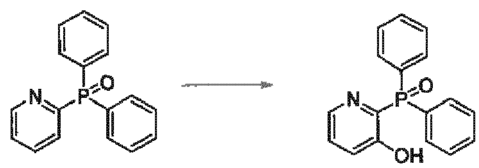

| | |
|---|---|
| diphenyl(pyridin-2-yl)phosphine oxide | 2.0 g, 1.0 eq., 7.2 mmol |
| 2-isopropoxy-4,4,5,5-tetramethyl-1,3,2-dioxaborolane | 4.35 mL, 3.0 eq., 21.5 mmol |
| Lithium diisopropylamide (LDA) | 9.56 mL, 2.0 eq., 14.3 mmol |
| THF | 50 mL |
| Chloroform | 50 mL |
| Hydrogen peroxide | 10 mL |
| DCM | 15 mL |

The starting material was dissolved in dry THF and cooled to -78°C. The borolane was added and the mixture

stirred for 20 min. The LDA solution was added drop wise and the temperature was allowed to rise slowly to room temperature. The reaction was stirred for 3 days at room temperature. The solvent was removed under reduced pressure and the residue was dissolved in chloroform. Hydrogen peroxide was added slowly at o°C and the mixture was stirred overnight at room temperature. The mixture was extracted with chloroform and brine. The organic phase was dried over magnesium sulphate and the solvent removed under reduced pressure. The residue was dissolved in DCM and precipitated with hexane. The solid was filtered off, washed with hexane and dried in vacuum.

Yield: 1.4 g (67 %), GCMS purity 100 %, structure confirmed by $^1$H-NMR, □ (ppm) = 11.48 (s, 1H, OH), 8.25 (d X from ABX system, *J* = 4.5Hz, 1H), 7.90 (dd, *J* = 12Hz and 7.5Hz, 4H), 7.58 (br t, *J* = 7Hz, 2H), 7.50 (td, *J* = 7.5Hz and 3Hz, 4H), 7.30 (ddd, B from ABX system, 1H), 7.24 (br dd, A from ABX system, 1H).

*Step 3: lithium 2-(diphenylphosphoryl)pyridin-3-olate (1)*

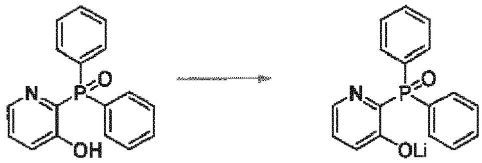

| | |
|---|---|
| (3-hydroxypyridin-2-yl)diphenylphosphine oxide | 1.0 g, 1.0 eq., 3.4 mmol |
| Lithium tert-butoxide | 0.27 g, 1.0 eq., 3.4 mmol |
| Acetonitrile | 40 mL |

The starting material was suspended in dry acetonitrile. The lithium tert-butoxide was added at room temperature and the mixture was heated at reflux for 13 hours. The solid was filtered off, washed with acetonitrile and dried in vacuum.

Yield: 0.865 g (87 %), TGA-DSC: m.p. 442°C

Analytical data (after sublimation):

TGA-DSC: m.p. 445 °C

Elemental analysis: 67.6 % C-content (theory 67.79 %), 4.48 % H-content (theory 4.35 %), 4.64 % N-content (theory 4.65 %)

Synthesis of lithium 2-fdiphenylphosphoryl)phenolate (ND-13)

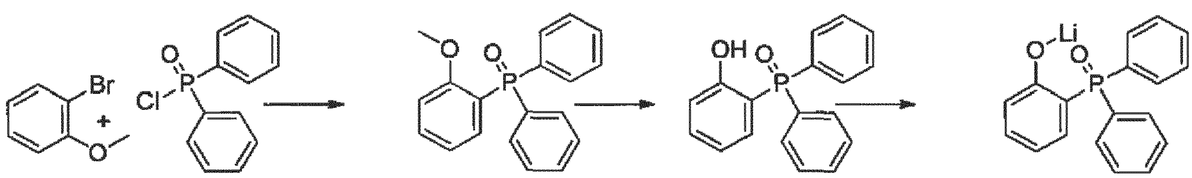

*Step 1: (2-methoxyphenyl)diphenylphosphine oxide*

A solution of 3.36 mL (5.0 g, 26.7 mmol, 1.05 eq.) o-bromoanisole in 20 mL dry THF from SPS was slowly added to a suspension of magnesium turnings (0.98 g, 40.1 mmol, 1.57 eq.) in 20 mL THF, in presence of a catalytic amount of elemental iodine. After the initial temperature rise was over, the reaction mixture was refluxed for 2 h, then let return to room temperature and inert filtered. The filtrate was cooled at -50 °C and a solution of 6 g (25.4 mmol, 1 eq.) of diphenylphosphinyl chloride in 20 mL THF was added drop wise. The suspension was allowed to warm slowly to room temperature and stirred overnight. The mixture was then refluxed for 3 h, and then cooled down to room temperature. The reaction was quenched by the addition of 10 mL methanol. The solvents were evaporated under vacuum, the residue was suspended in 50 mL chloroform and filtered. The filtrate was evaporated to afford (2-methoxyphenyl)diphenylphosphine oxide quantitatively (7.8 g, 25.4 mmol). The crude product was used without further purification.

GC-MS: m/z = 308 (96 % purity)

*Step 2:(2-hydroxyphenyl)diphenylphosphine oxide*

A solution of 7.8 g (25.4 mmol, 1 eq.) (2-methoxyphenyl)diphenylphosphine oxide in 20 mL dry DCM was cooled to -5 °C. To the reaction mixture, 28 mL (1.1 eq.) of a 1M boron tribromide solution in DCM were slowly added. The cooling bath was removed and the reaction was stirred at room temperature overnight. After quenching with 10 mL methanol, the mixture was neutralized with a saturated aqueous sodium hydrogen carbonate solution. Extraction from this mixture with 50 mL chloroform followed by evaporation and precipitation from chloroform with hexane afforded 4.1 g (13.9 mmol, 55 % yield) (2-hydroxyphenyl)diphenylphosphine oxide.

HPLC purity: 97 % (UV detector at 300 nm)

*Step 3: Lithium 2-(diphenylphosphoryl)phenolate (1)*

To 4.0 g (13.6 mmol, 1eq.) (2-hydroxyphenyl)diphenylphosphine oxide suspended in 80 mL dry AcN 109 mg (13.6 mmol, 1 eq.) lithium hydride was added under argon stream. The suspension was stirred overnight at room temperature, then filtered and washed with AcN to afford 3.40 g (83 % yield) of a grey powder. Further purification was achieved by gradient sublimation.

HPLC: 97 % (250 nm), 98 % (300 nm)

DSC: melting point: 436 °C (onset)

$^{1}$H-NMR ($CD_3OD$, 500.13 MHz): $\delta$[ppm] = 6.38 (broad s, 1H), 6.65 (m, 1H), 6.77 (broad s, 1H), 7.18 (t, $J$ = 8 Hz, 1H), 7.42 (td, $J$ = 3 Hz and 8 Hz, 4H), 7.50 (m, 2H), 7.65 (m, 4H).

$^{13}$C-NMR ($CD_3OD$, 125.76 MHz, with P-C coupling): $\delta$[ppm] = 114.01 (d, $J$ = 11 Hz), 115.80 (d, $J$ = 3 Hz), 122.19 (d, $J$ = 10 Hz), 129.35 (d, $J$ = 12 Hz), 132.69 (d, $J$ = 15 Hz), 133.34 (d, $J$ = 105 Hz), 134.34 (s), 134.64 (d, $J$ = 10 Hz), 135.19 (s), 135.73 (d, $J$ = 3 Hz).

$^{31}$P-NMR ($CD_3OD$, 125.76 MHz, without P-C coupling): $\delta$[ppm] = 37.28.

General procedure for fabrication of OLEDs

For the top emission OLED devices a substrate with dimensions of 150 mm × 150 mm × 0.7 mm was ultrasonically cleaned with a 2% aqueous solution of Deconex FPD 211 for 7 minutes and then with pure water for 5 minutes, and dried for 15 minutes in a spin rinse dryer. Subsequently, Ag was deposited as anode at a pressure of 10-5 to 10-7 mbar.

Then, HT-1 and D-1 were vacuum co-deposited on the anode to form a HIL. Then, HT-1 was vacuum deposited on the HIL to form an HTL. Then, HT-2 was vacuum deposited on the HTL to form an electron blocking layer (EBL).

Afterwards the emission layer was formed on the EBL by co-deposition of HOST-1 and EMITTER-i.

Then, ET-1 was vacuum deposited onto the emission layer to form the HBL (= a-ETL). Then, the ETL was formed on the HBL from materials as in Table 4, compositions in Table 5 and Table 6.

Then, the EIL is formed as a single layer on the ETL by depositing the compound of formula (I) (ND-1 and ND-13 as in Table 5 and Table 6) for the inventive examples OLED 1 to OLED 10.

For the comparative examples C.Ex. 1 to C.Ex. 4, the EIL is formed on the ETL by depositing first LiQ.

Then, the cathode sub-layer is formed on the EIL for inventive examples OLED 6 to OLED 10 and for comparative examples C.Ex. 1 to C.Ex.4 by depositing Yb.

Ag:Mg is then evaporated onto the EIL at a rate of 0.01 to 1 Å/s at 10-7 mbar to form a cathode.

A cap layer of HT-3 is formed on the cathode.

The details of the layer stack in the top emission OLED devices are given below. A slash "/" separates individual layers. Layer thicknesses are given in squared brackets [...], mixing ratios in wt% given in round brackets (...):

Layer stack details

*Inventive OLED type A:*

Ag [100nm] / HT-1:D-1 (wt% 92:8) [10 nm] / HT-1 [132 nm] / HT-2 [5 nm] / H09:BD200 (wt% 97:3) [20 nm] / ET-1 (=a-ETL) [5 nm] / ETL [30 nm] / Compound of formula (I) [1.5 nm] / Ag:Mg (wt% 90:10) [13 nm] / HT-3 [75 nm].

*Inventive OLED type B:*

Ag [100nm] / HT-1:NDP-9 D-1 (wt% 92:8) [10 nm] / HT-1 [132 nm] / HT-2 [5 nm] / H09:BD200 (wt% 97:3) [20 nm] / ET-1 (=a-ETL) [5 nm] / ETL [30 nm] / Compound of formula (I) [1.5 nm] / Yb [2 nm] / Ag:Mg (wt% 90:10) [13 nm] / HT-3 [75 nm].

*Comparative examples (C.Ex):*

Ag [100nm] / HT-1:NDP-9 D-1 (wt% 92:8) [10 nm] / HT-1 [132 nm] / HT-2 [5 nm] / H09:BD200 (wt% 97:3) [20 nm] / ET-1 (=a-ETL) [5 nm] / ETL [30 nm] / LiQ [1.5 nm] / Yb [2 nm] / Ag:Mg (wt% 90:10) [13 nm] / HT-3 [75 nm].

Table 4: List of compounds used

| | IUPAC name | Reference |
|---|---|---|
| HT-1 | N-([1,1'-biphenyl]-2-yl)-N-(9,9-dimethyl-9H-fluoren-2-yl)-9,9'-spirobi[fluoren]-2-amine [CAS 1364603-07-5] | WO2012034627 |
| HT-2 | N-([1,1'-biphenyl]-4-yl)-9,9-diphenyl-N-(4-(triphenylsilyl) phenyl)-9H-fluoren-2-amine [CAS 1613079-70-1] | WO2014088047 |
| D-1 | 4,4',4"-((1E,1'E,1"E)-cyclopropane-1,2,3-triylidenetris (cyanomethanylylidene))tris(2,3,5,6-tetrafluorobenzonitrile) [CAS 1224447-88-4] | US2008265216 |
| HOST-1 | H09 (Fluorescent-blue host material) | Commercially available from Sun Fine Chemicals, Inc, S. Korea |
| EMITTER-1 | BD200 (Fluorescent-blue emitter material) | Commercially available from Sun Fine Chemicals, Inc, S. Korea |
| LiQ | 8-Hydroxyquinolinolato-lithium [CAS 850918-68-2] | WO2013079217 |
| HT-3 | N-([1,1'-biphenyl]-4-yl)-9,9-dimethyl-N-(4-(9-phenyl-9H-carbazol-3-yl)phenyl)-9H-fluoren-2-amine [CAS 1242056-42-3] | US2016322581 |
| ET-1 | 2,4-diphenyl-6-(4',5',6'-triphenyl-[1,1':2',1'':3'',1''':3''',1''''-quinquephenyl]-3''''-yl)-1,3,5-triazine [CAS 2032364-64-8] | WO2016171358 |
| ET-2 | (3-(4-(4-(4,6-diphenyl-1,3,5-triazin-2-yl)phenyl)naphthalen-1-yl)phenyl)dimethylphosphine oxide [CAS 2253724-56-8] | EP 3407401 |
| ET-3 | 2-([1,1'-biphenyl]-3-yl)-4-phenyl-6-(3-(10-phenylanthracen-9-yl)phenyl)-1,3,5-triazine [CAS 2437303-42-7] | WO20120793 |
| ET-4 | 1-(4-(10-([1,1'-biphenyl]-4-yl)anthracen-9-yl)phenyl)-2-ethyl-1H-benzo[d]imidazole [CAS 1254961-38-0] | WO10122810 |

(continued)

| | IUPAC name | Reference |
|---|---|---|
| ET-5 | 4'-(4-(4-(4,6-diphenyl-1,3,5-triazin-2-yl)phenyl)naphthalen-1-yl)-[1,1'-biphenyl]-4-carbonitrile [CAS 2032421-37-5] | WO 2016171406 |

Technical Effect of the invention

The OLED devices according to the invention show improved efficiency at comparable voltage in devices comprising an electron injection layer according to claim 1.

Table 5 showing inventive OLED Type A:

| OLED device | ETL | EIL1 | Layer Thickness | EIL2 | Layer Thickness | V (% of comparative reference) @ 10mA/cm$^2$ | Ceff (% of comparative reference) @ 10mA/cm$^2$ |
|---|---|---|---|---|---|---|---|
| C.Ex 1. | ET-2:ET-3 (20:80 wt%) | LiQ | 1.5 | Yb | 2 | **100** | **100** |
| OLED 1 | ET-2:ET-3 (20:80 wt%) | ND-13 | 1.5 | - | - | 101 | 113 |
| OLED 2 | ET-2:ET-3 (20:80 wt%) | ND-1 | 1.5 | - | - | 101 | 106 |
| C.Ex. 2 | ET-4 | LiQ | 1.5 | Yb | 2 | **100** | **100** |
| C.Ex. 3 | ET-4 | LiQ | 1.5 | - | - | **182** | **72** |
| OLED 3 | ET-4 | ND-13 | 1.5 | - | - | 100 | 110 |
| C.Ex. 4 | ET-5 | LiQ | 1.5 | Yb | 2 | **100** | **100** |
| OLED 4 | ET-5 | ND-13 | 1.5 | - | - | 104 | 109 |
| OLED 5 | ET-5 | ND-1 | 1.5 | - | - | 107 | 105 |

Table 6 showing inventive OLED Type B:

| OLED device | ETL | EIL1 | Layer Thickness | EIL2 | Layer Thickness | V (% of comparative reference) @ 10mA/cm$^2$ | Ceff (% of comparative reference) @ 10mA/cm$^2$ |
|---|---|---|---|---|---|---|---|
| C.Ex 1 | ET-2:ET-3 (20:80 wt%) | LiQ | 1.5 | Yb | 2 | **100** | **100** |
| OLED 6 | ET-2:ET-3 (20:80 wt%) | ND-13 | 1.5 | Yb | 2 | 100 | 101 |
| OLED 7 | ET-2:ET-3 (20:80 wt%) | ND-1 | 1.5 | Yb | 2 | 100 | 101 |
| C.Ex. 2 | ET-4 | LiQ | 1.5 | Yb | 2 | **100** | **100** |

(continued)

| OLED device | ETL | EIL1 | Layer Thickness | EIL2 | Layer Thickness | V (% of comparative reference) @ $10mA/cm^2$ | Ceff (% of comparative reference) @ $10mA/cm^2$ |
|---|---|---|---|---|---|---|---|
| OLED 8 | ET-4 | ND-13 | 1.5 | Yb | 2 | 100 | 101 |
| OLED 9 | ET-4 | ND-1 | 1.5 | Yb | 2 | 100 | 102 |
| C.Ex. 4 | ET-5 | LiQ | 1.5 | Yb | 2 | **100** | **100** |
| OLED 10 | ET-5 | ND-1 | 1.5 | Yb | 2 | 100 | 102 |

The features disclosed in the foregoing description and in the dependent claims may, both separately and in any combination thereof, be material for realizing the aspects of the disclosure made in the independent claims, in diverse forms thereof.

## Claims

1. An organic light emitting diode comprising a non-transparent substrate, an anode, a cathode, an emission layer, an electron injection layer, and an electron transport layer;

wherein

- the emission layer, the electron injection layer and the electron transport layer are arranged between the anode and the cathode;
- the electron injection layer and the electron transport layer are arranged between the emission layer and the cathode;
- the electron injection layer is in direct contact to the electron transport layer;
- the electron injection layer is in direct contact to the cathode; and
- the electron injection layer consists of a compound of Formula (I) or of a mixture of two or more compounds of Formula (I)

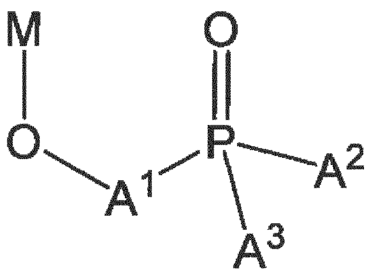

(I)

wherein

- M is an alkali metal;
- $A^1$ is selected from $C_6$ to $C_{60}$ arylene or $C_2$ to $C_{42}$ heteroarylene;
- $A^2$ and $A^3$ are independently selected from the group consisting of $C_6$ to $C_{30}$ aryl, $C_2$ to $C_{30}$ heteroaryl, and $C_1$ to $C_{16}$ alkyl;
- each $Ar^2$ to $Ar^5$ may independently be unsubstituted or substituted with one or more substituents independently selected from the group consisting of $C_6$ to $C_{12}$ aryl, $C_3$ to $C_{11}$ heteroaryl, $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, -O-Li; CN and $PY(R^{10})_2$, wherein Y is selected from O, S or Se, preferably O and $R^{10}$ is independently selected from $C_6$ to $C_{12}$ aryl, $C_3$ to $C_{12}$

heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $A^2$ and $A^3$ may be linked to each other.

**2.** The organic light emitting diode according to claim 1, wherein

- the cathode comprises a cathode sub-layer;
- the cathode sub-layer comprises a rare earth metal; and
- the cathode sub-layer is in direct contact with the electron injection layer.

**3.** The organic light emitting diode according to claim 2, wherein the cathode sub-layer has a thickness from 0.5 nm to 5 nm.

**4.** The organic light emitting diode according to any of the preceding claims, wherein M is Li.

**5.** The organic light emitting diode according to any of the preceding claims, wherein $A^1$ is selected from $C_6$ to $C_{20}$ arylene or $C_2$ to $C_{18}$ N-containing heteroarylene, wherein $A^1$ may be unsubstituted or substituted with one or more substituents independently selected from the group consisting $C_1$ to $C_6$ alkyl, D, $C_3$ to $C_6$ branched alkyl, $C_3$ to $C_6$ cyclic alkyl, partially or perfluorinated $C_1$ to $C_6$ alkyl, halogen, CN and $PO(R^{10})_2$, and $R^{10}$ is independently selected from $C_6$ to $C_{12}$ aryl or $C_3$ to $C_{12}$ heteroaryl.

**6.** The organic light emitting diode according to any of the preceding claims, wherein $A^2$ and A3 are independently selected from $C_6$ to $C_{12}$ arylene or $C_2$ to $C_8$ N- containing heteroarylene, wherein $A^2$ and $A^3$ may be independently unsubstituted or substituted with one or more substituents independently selected from the group consisting $C_1$ to $C_6$ alkyl, D, $C_3$ to $C_6$ branched alkyl, $C_3$ to $C_6$ cyclic alkyl, partially or perfluorinated $C_1$ to $C_6$ alkyl, halogen, -O-Li and CN.

**7.** The organic light emitting diode according to any of the preceding claims, wherein $A^1$ comprises a 6-membered aromatic ring and the moieties -O-M and $P(=O)A^2A^3$ are bonded to the 6-membered aromatic ring in ortho-position with respect to each other.

**8.** The organic light emitting diode according to any of the preceding claims, wherein the compound of formula (I) is selected from the group consisting of ND-1 to ND-20

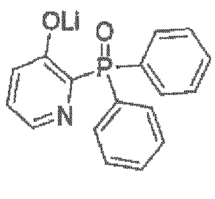

ND-1

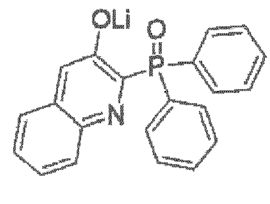

ND-2

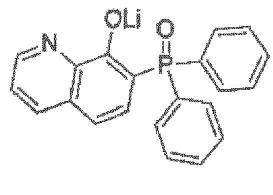

ND-3

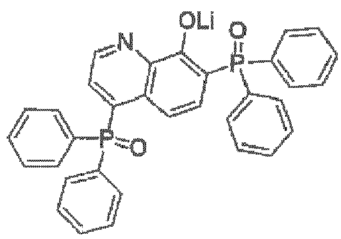

ND-4

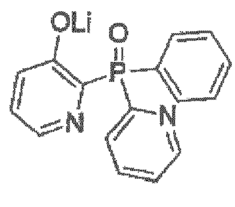

ND-5

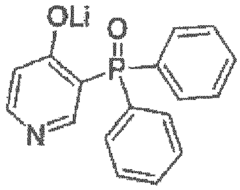 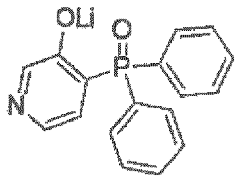 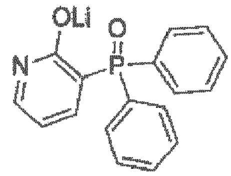

ND-6 ND-7 ND-8

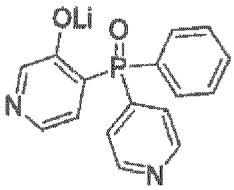 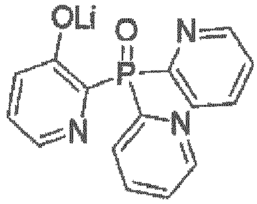 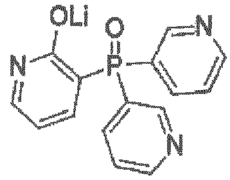

ND-9 ND-10 ND-11

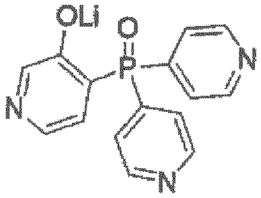 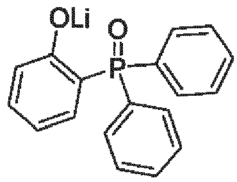 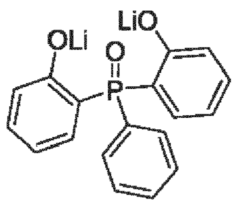 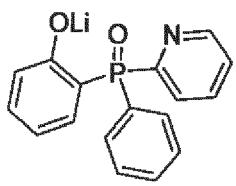

ND-12 ND-13 ND-14 ND-15

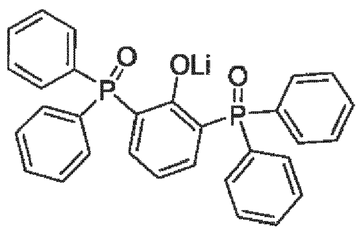 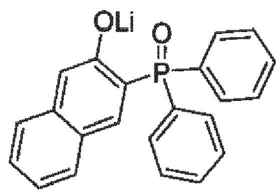 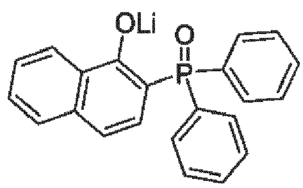

ND-16 ND-17 ND-18

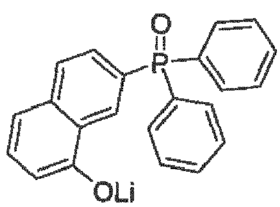 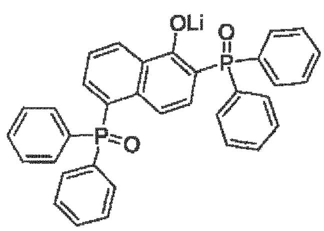

ND-19 ND-20.

**9.** The organic light emitting diode according to any of the preceding claims, wherein the electron injection layer has a thickness from 0.1 to 10 nm.

**10.** The organic light emitting diode according to any of the preceding claims, wherein the electron transport layer comprises an n-type dopant.

**11.** The organic light emitting diode according to any of the claims 1 to 9, wherein the electron transport layer is free of n-dopant.

**12.** The organic light emitting diode according to any of the preceding claims, wherein

- the organic light emitting diode further comprises an auxiliary electron transport layer; and
- the auxiliary electron transport layer is arranged between the emission layer and the electron transport layer.

**13.** The organic light emitting diode according to claim 17, wherein the auxiliary electron transport layer is in direct contact with the electron transport layer.

**14.** Display device comprising the organic light emitting diode according to any of the preceding claims.

**15.** Lighting device comprising the organic light emitting diode according to any of the claims 1 to 14.

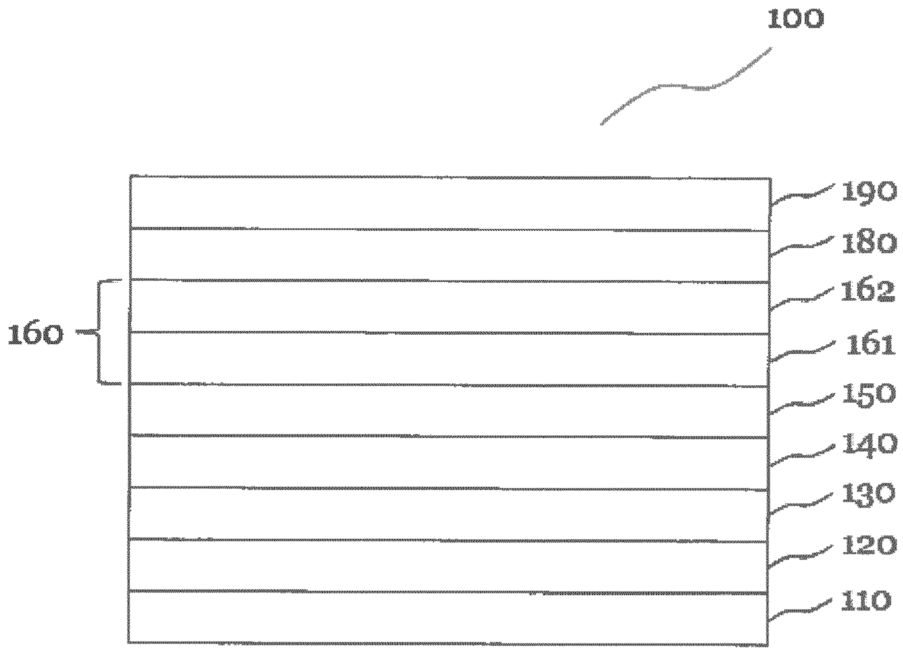


Fig. 1

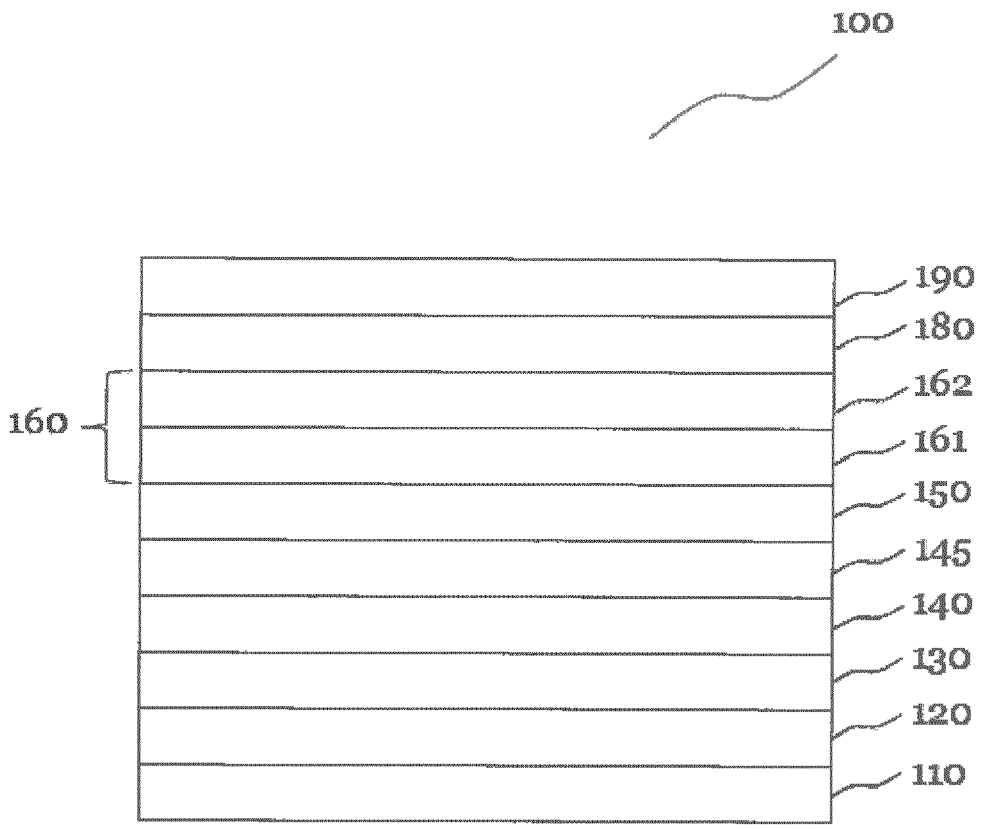


Fig. 2

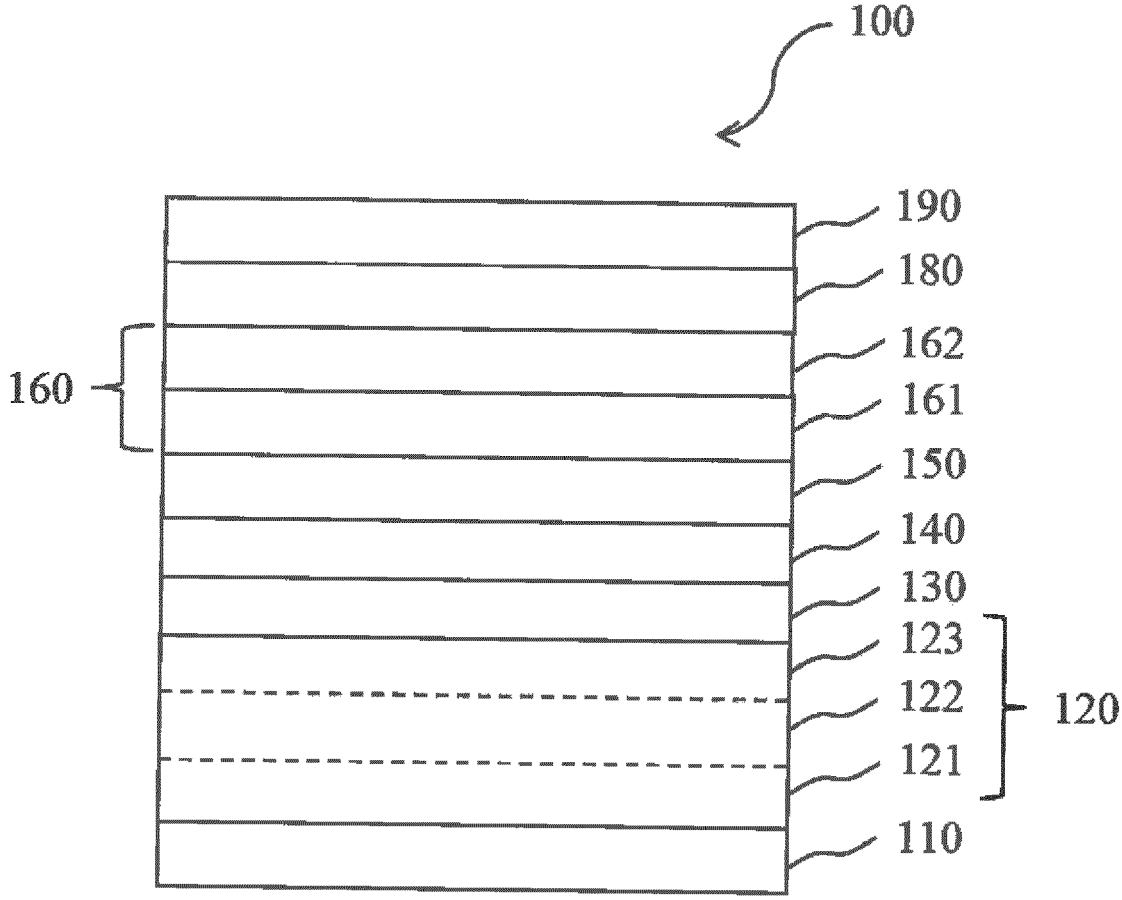


Fig. 3

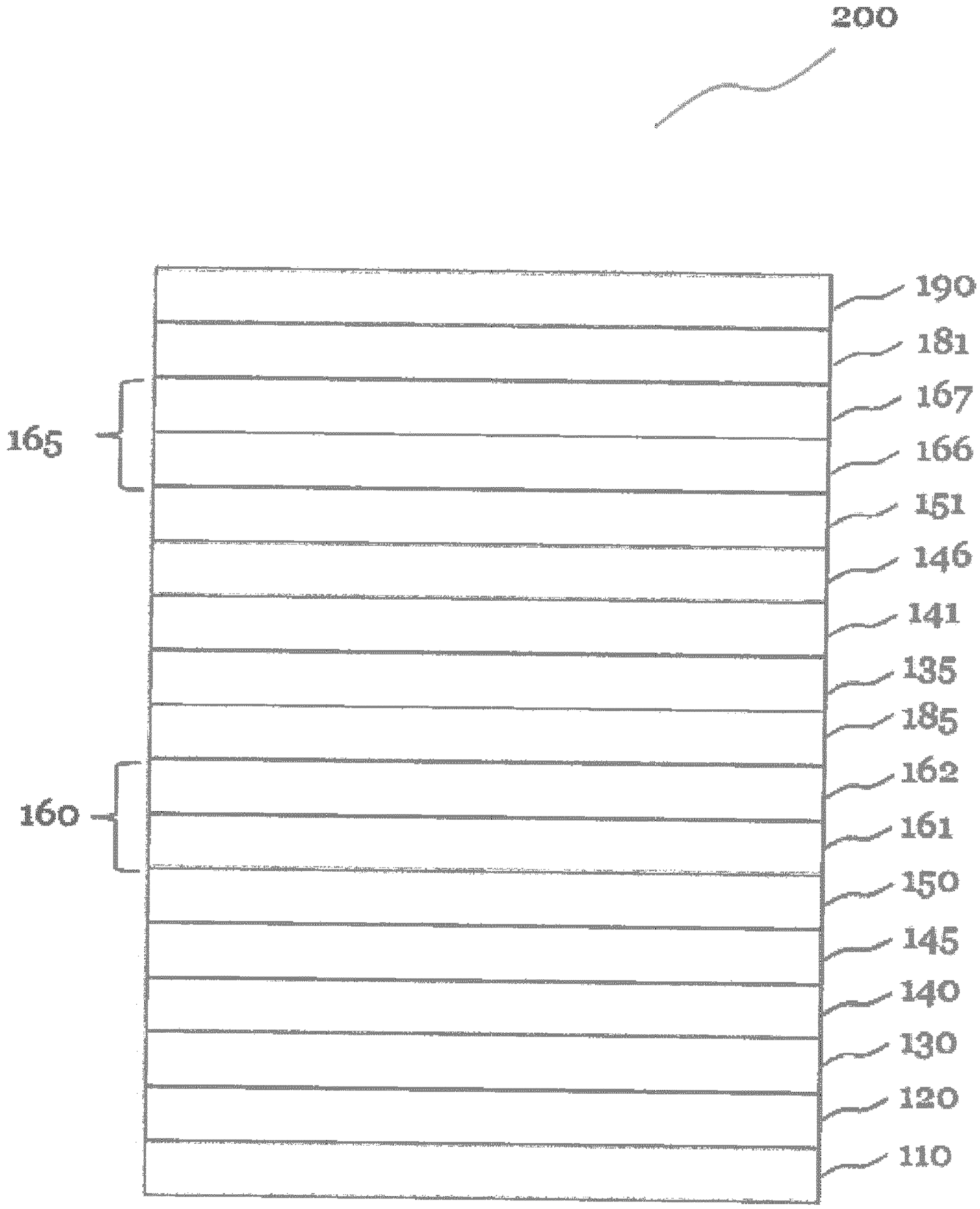
200
190
181
167
166
151
146
141
135
185
162
161
150
145
140
130
120
110
165
160

Fig. 4

Europäisches Patentamt
European Patent Office
Office européen des brevets

# EUROPEAN SEARCH REPORT

Application Number
EP 21 20 6691

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 093 288 A1 (NOVALED GMBH [DE]) 16 November 2016 (2016-11-16) * paragraph [0051] - paragraph [0063]; table 1 * * paragraph [0085] - paragraph [0087]; tables 2-4 * * paragraph [0273] - paragraph [0321]; tables 6-8 * ----- | 1-15 | INV. H01L51/50 |
| X | EP 3 208 861 A1 (NOVALED GMBH [DE]) 23 August 2017 (2017-08-23) * paragraph [0124] - paragraph [0219]; tables 3-6 * * paragraph [0289] - paragraph [0293] * * paragraph [0307] - paragraph [0372]; figure 7; tables 7,8 * ----- | 1-15 | |
| | | | TECHNICAL FIELDS SEARCHED (IPC) |
| | | | H01L |

The present search report has been drawn up for all claims

1

| Place of search | Date of completion of the search | Examiner |
|---|---|---|
| The Hague | 14 April 2022 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 21 20 6691

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2022

| Patent document cited in search report | Publication date | Patent family member(s) | Publication date |
| --- | --- | --- | --- |
| EP 3093288 A1 | 16-11-2016 | CN 107750404 A | 02-03-2018 |
| | | EP 3093288 A1 | 16-11-2016 |
| | | EP 3294727 A1 | 21-03-2018 |
| | | EP 3872074 A1 | 01-09-2021 |
| | | KR 20180005199 A | 15-01-2018 |
| | | US 2018145263 A1 | 24-05-2018 |
| | | WO 2016180891 A1 | 17-11-2016 |
| EP 3208861 A1 | 23-08-2017 | CN 108701773 A | 23-10-2018 |
| | | EP 3208861 A1 | 23-08-2017 |
| | | EP 3417495 A1 | 26-12-2018 |
| | | KR 20180110681 A | 10-10-2018 |
| | | US 2021210708 A1 | 08-07-2021 |
| | | US 2021376259 A1 | 02-12-2021 |
| | | WO 2017140780 A1 | 24-08-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1837926 A1
- WO 07107306 A1
- WO 07107356 A1
- EP 2722908 A1
- EP 1970371 A1
- WO 2013079217 A1
- WO 2012034627 A
- WO 2014088047 A
- US 2008265216 A
- WO 2013079217 A
- US 2016322581 A
- WO 2016171358 A
- EP 3407401 A
- WO 20120793 A
- WO 10122810 A
- WO 2016171406 A


### Non-patent literature cited in the description


- **YASUHIKO SHIROTA ; HIROSHI KAGEYAMA.** *Chem. Rev.*, 2007, vol. 107, 953-1010
- *CHEMICAL ABSTRACTS,* 1364603-07-5
- *CHEMICAL ABSTRACTS,* 1613079-70-1
- *CHEMICAL ABSTRACTS,* 1224447-88-4
- *CHEMICAL ABSTRACTS,* 850918-68-2
- *CHEMICAL ABSTRACTS,* 1242056-42-3
- *CHEMICAL ABSTRACTS,* 2032364-64-8
- *CHEMICAL ABSTRACTS,* 2253724-56-8
- *CHEMICAL ABSTRACTS,* 2437303-42-7
- *CHEMICAL ABSTRACTS,* 1254961-38-0
- *CHEMICAL ABSTRACTS,* 2032421-37-5